# EUROPEAN PATENT APPLICATION

(11) **EP 4 734 732 A1**
(43) Date of publication of application: **29.04.2026**
(21) Application number: 24306797.2
(22) Date of filing: 24.10.2024
(51) Int. Cl.: H10N 15/10

(54) **ELECTROCALORIC POLYMER-BASED MULTILAYER ELEMENT**

(71) Applicant: ARKEMA FRANCE, 92800 Puteaux (FR); Luxembourg Institute of Science and Technology (LIST), 4362 Esch/Alzette (LU)
(72) Inventor: DEFAY, Emmanuel, 4362 Esch/Alzette (LU); PRAH, Uros, 4362 Esch/Alzette (LU); KOVACOVA, Veronika, 4362 Esch/Alzette (LU); DOMINGUES DOS SANTOS, Fabrice, 92705 Colombes (FR)
(74) Representative: Bandpay & Greuter

(57) **Abstract**

The invention relates to an electrocaloric multilayer element (10) comprising a stack of layers along a transverse direction (11), said stack of layers comprising a first outermost polymer layer (15, 22, 32) and a second outermost polymer layer (16, 23, 33) at opposite ends of the stack and, between the first outermost polymer layer (15, 22, 32) and second outermost polymer (16, 23, 33), a plurality of electrocaloric polymer layers (12) and a plurality of electrode layers (13).

## Description

### Technical field

The present invention relates to an electrocaloric polymer-based multilayer element comprising a stack of layers along a transverse direction, comprising electrocaloric polymer layers and electrode layers.

### Technical background

The development of highly efficient and environmentally friendly energy systems is a primary concern for mitigating global warming and promoting a sustainable use of natural resources. Five billion refrigeration, air-conditioning, and heat pump systems are in operation, which are estimated to consume 20% of global electricity, and the absolute amount of air conditioning units is predicted to double by 2040. Current vapor compression-based refrigeration systems have reached their thermodynamic limit after 100 years of advancements. Most of these systems work with fluorinated refrigerants and are responsible for producing up to 10% of the overall greenhouse gas emissions in the world. This is due to indirect carbon dioxide emissions coming from the electricity production, as well as direct leakage of fluorinated refrigerants. Moreover, these systems are not suitable for the sort of miniaturization needed for several types of cooling applications.

Coming up with sustainable sources of electricity is also one of the challenges of this century. The research field of materials for energy harvesting stems from this motivation, including thermoelectrics, photovoltaics and thermophotovoltaics. Pyroelectric materials, converting temperature periodic variations into electrical energy, have been considered as sensors and energy harvesters, although there is a lack of materials and devices able to harvest in the joule range.

Solid-state caloric materials have been pinpointed as one promising solution for the above-mentioned problems because they can be highly efficient for both producing cold/heat and energy harvesting and have no direct global warming potential.

Caloric materials undergo reversible adiabatic temperature (or isothermal entropy) changes upon modifications in external applied fields, which can be magnetic (magnetocalorics), hydrostatic pressure (barocalorics), uniaxial stress (elastocalorics), and electric (electrocalorics).

The electrocaloric effect is a property of certain polar dielectric materials which manifests itself by a variation in temperature when they are subjected to a variable electric field. The physical origin of this phenomenon is related to the change in the dipolar order, and therefore to a variation in the dipolar entropy induced by the application of an electric field. The application of an electric field orders and orients the dipoles of these materials, which brings about a decrease in their dipolar entropy and an increase in their temperature under adiabatic conditions. Conversely, the reduction or suppression of the electric field brings about an increase in their dipolar entropy and a reduction in their temperature under adiabatic conditions. Thus, an electrocaloric material is characterized, under given experimental conditions, by a variation in adiabatic temperature ΔT_{EC} for an applied electric field E under adiabatic conditions. Alternatively, an electrocaloric material can also be characterized by a change in isothermal entropy ΔS_{EC} for an applied electric field E under isothermal conditions.

Ferroelectric materials and relaxor ferroelectrics, due to strong coupling between the applied electric fields and their dipolar structure, have high electrocaloric performance qualities. In particular, this coupling is at a maximum close to or slightly above the phase transitions: Ferroelectric→Paraelectric (FE→PE) or Relaxor Ferroelectric→Paraelectric (RFE→PE), due in particular to a strong reversible variation in the polarization of these materials under an electric field. In other words, close to the phase transitions FE→PE or RFE→PE, a relatively weak variation in electric field generates significant variations in entropy and in temperature.

Ceramics having an electrocaloric effect have been used for both producing cold/heat and energy harvesting, as shown in the following documents:
- Large Electrocaloric effects in oxide multilayer capacitors over a wide range of temperature, Nair et al., Nature, 575, 468-472 (2019),
- Giant temperature span in electrocaloric regenerator, Torelló et al., Science, 370 (6512), 125-129 (2020),
- Large harvested energy with non-linear pyroelectrics modules, Lheritier et al., Nature, 609, 718-721 (2022),
- High cooling performance in a double-loop electrocaloric heat pump, Li et al., Science, 382 (6672), 801-805 (2023).

These documents disclose the use of PbSc_{0.5}Ta_{0.5}O₃ (PST) in multilayer capacitors (MLCs). The three last papers describe cooler proof-of-concepts involving a fluid that collect heat induced by the electrocaloric effect of the ceramic-based capacitors (structure called regenerator). However, the fluid in use is a dielectric fluid that has thermal properties that are not as good as those of water. It would be very beneficial to find a solution to use water instead. For the moment, these materials cannot be used with water. Besides, despite interesting properties, these ceramics-based capacitors are costly because of the use of high temperatures during their process of production and of the nature of raw materials.

"Ferroelectric" and "relaxor ferroelectric" polymer materials are also known; among them, fluoropolymers based on vinylidene fluoride (VDF) and on trifluoroethylene (TrFE) have been the most studied ones.

VDF-based fluoropolymers have in particular been used as multilayer capacitors.

The document A chip scale electrocaloric effect based cooling device, H. Gu et al., Appl. Phys. Lett., 102, 122904 (2013), discloses the use of irradiated P(VDF) multilayers with gold electrodes. The document also discloses the use of an adhesive to improve the adhesion of the individual layers by simply bonding them together to form a multilayer structure and the use of stainless steel foil to improve the mechanical strength of the multilayer. Adhesive layers and stainless steel foils significantly reduce the ratio between electrocalorically active and inactive masses, resulting in a lower electrocaloric response. In addition, the adhesive layers weaken the heat transfer process in the multilayer structure, which is important for use in the cooling device.

The documents Highly efficient electrocaloric cooling with electrostatic actuation, R. Ma et al., Science 357 (6356), 1130-1134 (2017) and A cascade electrocaloric cooling device for large temperature lift, Y. Meng et al., Nature Energy, 5, 996-1002 (2020) both use carbon nanotubes as an electrode material. These documents disclose a bilayer structure rather than a multilayer structure, with only two polymer films sharing one electrode. The limited number of layers leads to a low thermal mass and poor mechanical stability, which limits their use in liquid-based systems.

The document 1-mW Vibration Energy Harvester Based on a Cantilever with Printed Polymer Multilayers, N. Godard et al., Cell Rep. Phys. Sci., 1 (6), 10068 (2020) discloses a multilayer structure prepared by screen-printing polymer films and polymer (PEDOT:PSS) electrodes. The process requires the presence of a thick substrate. The presence of polymer electrodes and of a thick substrate significantly reduces the ratio of electrocaloric active to inactive mass, making the design unsuitable for electrocaloric cooling applications.

Document WO 2021/116618 A1 discloses an electrocaloric VDF-based polymer comprising double bonds.

Document WO 2021/123460 A1 relates to an electrocaloric heat exchanger made of an electrocaloric material used as a cooling and/or heating device and also used as a device for producing electrical energy. The heat exchanger and the devices are not suitable for a water-based environment.

The above-mentioned prior-art using ceramics or VDF-based fluoropolymers in electrocaloric devices are not designed for use in a water-based environment.

Within this context, there is a need for an electrocaloric multilayer element having a better ratio of electrocaloric active mass over electrocaloric inactive mass enabling a better electrocaloric response and being mechanically stable.

There is also a need for an electrocaloric multilayer element being compatible with a water-based environment, enabling a more efficient heat transfer and having a reduced environmental impact.

### Summary of the invention

It is a first object of the invention to provide an electrocaloric multilayer element comprising a stack of layers along a transverse direction, said stack of layers comprising a first outermost polymer layer and a second outermost polymer layer at opposite ends of the stack and, between the first outermost polymer layer and second outermost polymer, a plurality of electrocaloric polymer layers and a plurality of electrode layers.

In some variations, the stack of layers comprises a plurality of units, each unit comprising an electrocaloric polymer layer and an electrode layer deposited on the electrocaloric polymer layer.

In some variations, the stack of layers successively comprises, from one end of the stack to an opposite end of the stack: a first unit, wherein the electrocaloric polymer layer of the first unit is the first outermost polymer layer; second to last units, wherein the electrocaloric polymer layer of each of the second to last units is in contact with the electrode layer of the preceding unit; the second outermost polymer layer, in contact with the electrode layer of the last unit.

In some variations, the stack of layers successively comprises, from one end of the stack to an opposite end of the stack: the first outermost polymer layer; a first group of units, comprising a first to last units, wherein the electrode layer of the first unit of the first group is in contact with the first outermost polymer layer, and the electrode layer of each of the second to last unit of the first group is in contact with the electrocaloric polymer layer of the preceding unit of the first group; a second group of units, comprising a first to last units, wherein the electrocaloric polymer layer of the first unit of the second group is joined with the electrocaloric polymer layer of the last unit of the first group, and the electrocaloric polymer layer of each of the second to last unit of the second group is in contact with the electrode layer of the preceding unit of the second group; and the second outermost polymer layer in contact with the electrode layer of the last unit of the second group.

In some variations, the stack of layers successively comprises, from one end of the stack to an opposite end of the stack: a first group of units, comprising a first to last units, wherein the electrocaloric polymer layer of the first unit of the first group is the first outermost polymer layer, and the electrocaloric polymer layer of each of the second to last units of the first group is in contact with the electrode layer of the preceding unit of the first group; an intermediate polymer layer; a second group of units, comprising a first to last units, wherein the electrocaloric polymer layer of the last unit of the second group is the second outermost polymer layer, and the electrode layer of each of the second to last units of the second group is in contact with the electrocaloric polymer layer of the preceding unit of the second group.

In some variations, the total number of units is from 2 to 100, preferably from 5 to 75 and more preferably from 10 to 50.

In some variations, the electrocaloric multilayer element comprises a plurality of stacks of layers, wherein, preferably, the stacks are formed as an integral element and the electrocaloric polymer layers are continuous from one stack to the next.

In some variations, the or each stack comprises a first set of electrode layers and a second set of electrode layers, wherein the electrode layers of the first set alternate with the electrode layers of the second set along the transverse direction in the or each stack.

In some variations, the electrocaloric multilayer element comprises a first electrical contact and a second electrical contact, the first electrical contact being electrically connected to the first set(s) of electrode layers, preferably *via* respective leads, the second electrical contact being electrically connected to the second set(s) of electrode layers, preferably *via* respective leads.

In some variations, the first electrical contact and the second electrical contact are located on a same lateral face of the electrocaloric multilayer element.

In some variations, all electrode layers and leads, if present, are encapsulated in polymer material, whereas the first electrical contact and the second electrical contact are not encapsulated in polymer material.

In some variations, each electrode layer comprises a metal chosen among the group of transition metals, preferably the metal is aluminum, copper, nickel, magnesium, tungsten, molybdenum, manganese, titanium, vanadium, chromium gold or platinum, more preferably the metal is copper; and/or each electrode layer has a thickness from 10 to 500 nm, preferably from 20 to 400 nm, preferably from 30 to 300 nm.

In some variations, each electrocaloric polymer layer has a thickness from 0.5 to 100 µm, preferably from 1 to 90 µm, preferably from 1.5 to 75 µm and more preferably from 2 to 50 µm.

In some variations, each electrocaloric polymer layer comprises a fluoropolymer comprising:
- a first repeat unit of formula -(CF₂-CH₂)-,
- optionally, a second repeat unit of formula -(CX₁X₂-CX₃X₄)-,
- optionally, a third repeat unit of formula -(CY₁Y₂-CY₃Z)-,
- optionally, a fourth repeat unit DB (for double bond) of formula -(CY₃=CF)-, -(CY₃=CX₁)-, -(CY₃=CX₂)-, -(CY₁=CY₃)- or -(CY ₂=CY₃)-;
in which:
X₁ and X₂ are independently -H, -F, or an alkyl group comprising from 1 to 3 carbon atoms which is optionally partially or completely fluorinated,
X₃ and X₄ are independently -F or an alkyl group comprising from 1 to 3 carbon atoms which is optionally partially or completely fluorinated, except for the combination where: X₁ and X₂ are both: -H and X₃ and X₄ are both: -F,
Y₁ and Y₂ are independently -H, -F, -CI or an alkyl group comprising from 1 to 3 carbon atoms which is optionally partially or completely fluorinated,
Y₃ is -F, -Cl or an alkyl group comprising from 1 to 3 carbon atoms which is optionally partially or completely fluorinated,
Z is a halogen atom other than -F.

In some variations, the fluoropolymer is selected from P(VDF-TrFE), P(VDF-TrFE-CTFE), P(VDF-TrFE-CFE), P(VDF-TrFE-DB), P(VDF-TrFE-CTFE-DB) and P(VDF-TrFE-CFE-DB) and their mixture, wherein VDF represents repeat units derived from vinylidene fluoride, TrFE represents repeat units derived from trifluoroethylene, CTFE represents repeat units derived from chlorotrifluoroethylene, and CFE represents repeat units derived from 1,1- or 1,2-chlorofluoroethylene.

In some variations, the stack has an electrocaloric active mass percentage from 50 to 99%, preferably 60 to 99% and more preferably 70 to 99%.

The invention also relates to a process for producing the electrocaloric multilayer element as described above, comprising assembling layers to form the stack of layers.

In some variations, the process comprises:
- a step of preparing a plurality of units, wherein each unit is made by depositing an electrode layer onto an electrocaloric polymer layer;
- a step of assembling the plurality of units together to form the stack of layers, preferably comprising performing thermal lamination, wherein more preferably the stack is heated to a temperature of 2 to 5°C below the melting point of the polymers of the electrocaloric polymer layers.

In some variations, the step of thermal lamination further comprises performing recrystallization, wherein preferably the stack is heated to a temperature of 2 to 20°C below the melting point of the polymers of the electrocaloric polymer layers.

The invention also relates to the use of the electrocaloric element as described above, for exchanging heat in contact with a heat-transfer liquid, the heat-transfer liquid being preferably chosen among water, an alcohol such as ethanol, ethylene glycol and propylene glycol, a silicone oil, a liquid metal or metal alloy such as galinstan, and being more preferably water.

In other terms, in this use, the electrocaloric element is in contact with the heat-transfer liquid and transfers heat to or from the heat-transfer liquid. This use may be for example implemented in an electrocaloric heat exchanger or regenerator.

The invention makes it possible to address the needs expressed above.

The configuration of the various layers makes it possible to use the electrocaloric multilayer element in a liquid, especially water-based, environment. Advantageously, all electrode layers and more generally all electrically conductive portions electrically configured to be electrically connected to a power source are encapsulated in polymer materials and physically separate from the environment.

Preferably, this configuration allows to increase the percentage of active mass in the electrocaloric multilayer element.

Preferably, the various layers are assembled without an adhesive, such as by thermal lamination, which may allow for better mechanical stability and a further increase of the percentage of active mass. Alternatively, in some less preferred embodiments, adhesive layers may be present between adjacent electrocaloric polymer layers and electrode layers. The adhesive layers may for example comprise an acrylate adhesive material.

### Brief description of the drawings

Fig. 1 schematically represents a cross-sectional view of an exemplary electrocaloric multilayer element according to a first embodiment
Fig. 2 schematically represents a top view of electrocaloric multilayer element according to a second embodiment.
Fig. 3 schematically represents a cross-sectional view of the electrocaloric multilayer element of Fig. 2 along dotted line A.
Fig. 4 schematically represents another cross-sectional view of the electrocaloric multilayer element of Fig. 2 along dotted line B.
Fig. 5 schematically represents a cross-sectional view of the electrocaloric multilayer element of Fig. 2 along dotted line C.
Fig. 6 schematically represents a cross-sectional view of an exemplary electrocaloric multilayer element according to a third embodiment, in an exploded view (left) and assembled (right).
Fig. 7 schematically represents a cross-sectional view of an exemplary electrocaloric multilayer element according to a fourth embodiment, in an exploded view (left) and assembled (right).
Fig. 8 schematically represents how individual elements can be assembled to make an electrocaloric multilayer element as shown for example in Fig. 2.
Fig. 9 is a graph showing the polarization of various multilayer elements as function of applied voltage at room temperature (25 °C), as explained in Example 1.
Fig. 10 is a graph showing the measured adiabatic temperature in two different multilayer elements as a function of applied temperature, and for different maximum voltages, as explained in Example 2.
Fig. 11 is a graph showing Polarization-Electric Field loops (PE loops) of an electrocaloric multilayer element at room temperature (25 °C) in air (1), deionized water (2) and in again air (3) as explained in Example 3.
Fig. 12 is a graph showing the maximum polarization, coercive electric field and remanent polarization, in the same assay as for Fig. 9 (see Example 3).
Fig. 13 is a graph showing Polarization-Electric Field loops (PE loops) of an electrocaloric multilayer element at room temperature (25 °C) in air (1), tap water (2) and in air again (3) as explained in Example 4.
Fig. 14 is a graph showing the maximum polarization, coercive electric field and remanent polarization, in the same assay as for Fig. 10 (see Example 4).

### Detailed description

The invention will now be described in more detail without limitation in the following description.

### Electrocaloric multilayer element

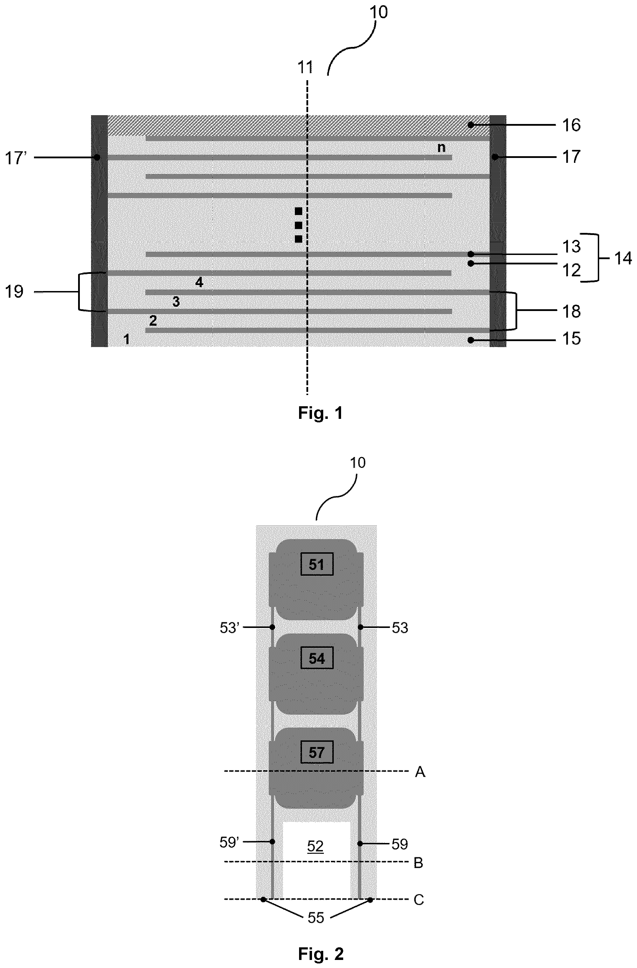

Making reference by way of illustration only to Fig. 1, the electrocaloric multilayer element 10 comprises a stack of layers along a transverse direction 11. The stack of layers comprises a first outermost polymer layer 15 and a second outermost polymer layer 16 at opposite ends of the stack. Between the first outermost polymer layer 15 and second outermost polymer 16, the electrocaloric multilayer element 10 comprises a plurality of electrocaloric polymer layers 12 and a plurality of electrode layers 13.

The electrocaloric multilayer element may comprise a single stack of layers. Alternatively, more than one stack may be present, as will be described in more detail below.

Each electrode layer 13 is formed of electrically conductive material.

The stack may comprise a plurality of units 14, wherein each unit comprises an electrocaloric polymer layer 12 and an electrode layer 13 deposited thereon. As will be described in more detail below, the stack may be formed by assembling the units 14 together.

As a result of the assembling, some of the individual electrocaloric polymer layers 12 may be fully or only partly fused into thicker, preferably substantially uniform, layers, in the areas where in an electrode layer 13 is not interposed between adjacent individual electrocaloric polymer layers 12.

Thus, as a result of the assembling, the electrode layers 13 may be embedded, i.e. encapsulated (preferably fully embedded, i.e. encapsulated) in polymer material.

In other terms, the electrocaloric polymer layers 12 are preferably continuous (and preferably also continuous with the first and second outermost polymer layers, if distinct), as will be described in more detail below.

The first outermost polymer layer 15 may be formed of the electrocaloric polymer layer 12 of one unit 14. Alternatively, the first outermost polymer layer 15 may be another polymer layer not belonging to one of the units 14.

The second outermost polymer layer 16 may be formed of the electrocaloric polymer layer 12 of one unit 13. Alternatively, the second outermost polymer layer 16 may be another polymer layer not comprised in one of the units 14.

The unit 14 closest to the first end of the stack can be designated as the first unit 1. The unit closest to the second end of the stack can be designated as the last unit n. In Fig.1, the units 14 are thus labeled as 1, 2, 3, 4, ... , n
Making reference to Fig. 1, the stack of layers may successively comprise, from a first end of the stack to an opposite, second end of the stack: a first unit 14, wherein the electrocaloric polymer layer 12 of the first unit 14 is the first outermost polymer layer 15; a second to last (n^{th}) units 14, designated as 2, 3... n on the drawing; and a second outermost polymer layer 16. The electrocaloric polymer layer 12 of each unit number i in the stack is in contact with the electrode layer 13 of the unit number i - 1 (for each integer i from 2 to n).

Each of these layers preferably extends along a plane. All of these planes are preferably parallel. The *"transverse direction"* 11 is then the direction which is orthogonal to the planes of the layers.

Preferably, each unit 14 may consist of the electrocaloric polymer layer 12 and the electrode layer 13. In other terms, there may be no intermediate material, and in particular no adhesive, between the electrocaloric polymer layer 12 and the electrode layer 13. In other, non-preferred variations, an adhesive layer may be present between the electrocaloric polymer layer 12 and the electrode layer 13, which may for example comprise an acrylate adhesive.

Within each unit 14, the electrocaloric polymer layer 12 may display a first face and a second face, preferably extending along a plane perpendicular to the transverse direction 11; and the electrode layer 13 may display a first face and a second face, preferably extending along a plane perpendicular to the transverse direction 11. The second face of the electrocaloric polymer layer 12 may be preferably in contact with the first face of the electrode layer 13. Still making reference to Fig.1, the first face of each layer is oriented towards the bottom of the drawing, while the second face is oriented towards the top of the drawing.

The second face of the electrode layer 13 (possibly together with a part of the second face of the electrocaloric polymer layer 12) of each unit 14 (except the last unit n) may face the first face of the electrocaloric polymer layer 12 of the next adjacent unit. Preferably, the second face of the electrode layer 13 (possibly together with a part of the second face of the electrocaloric polymer layer 12) of each unit 14 (except the last unit n) may be in contact with the first face of the electrocaloric polymer layer 12 of the next, adjacent unit. In other terms, there may preferably be no intermediate material, and in particular no adhesive, between adjacent units.

The second face of the electrode layer 13 (possibly together with a part of the second face of the electrocaloric polymer layer 12) of the last unit n may face the second outermost polymer layer 16. Preferably, the second face of the electrode layer 13 (possibly together with a part of the second face of the electrocaloric polymer layer 12) of the last n unit may be in contact with the second outermost polymer layer 16. In other terms, there may preferably be no intermediate material, and in particular no adhesive, between the last unit n and the outermost polymer layer 16.

Electrocaloric polymer layers 12 and electrode layers 13 may alternate within the stack along at least one line oriented parallel to the transverse direction 11, for example along a centerline of the stack.

Within each unit 14, the electrode layer 13 may totally cover the electrocaloric polymer layer 12.

Preferably, within each unit 14, the electrode layer 13 may only partially cover the electrocaloric polymer layer 12. In this case, the electrocaloric polymer layers 12 of adjacent units 14 may be joined (or fused) together, for example by lamination, to form a continuous polymer mass. Thus, electrocaloric polymer layers 12 and electrode layers 13 may alternate within the stack along at least one line oriented parallel to the transverse direction 11 (as mentioned above) but adjacent electrocaloric polymer layers 12 may be in contact (continuous) along at least one other line oriented parallel to the transverse direction 11. This facilitates encapsulation of the electrode layers.

The first and the second outermost polymer layers 15, 16 ensure the waterproofing of the electrocaloric multilayer element 10. This allows the use of the electrocaloric multilayer element 10 in a liquid environment, for example a water-based environment.

All units 14 may have the same orientation, as illustrated in Fig. 1, *i.e.* the second face of all electrode layers 13 of the units is oriented towards the same outermost polymer layer; in the case of the drawing, the second face of all electrode layers 13 of the units 14 is oriented towards the second outermost polymer 16 and away from the first outermost polymer layer 15.

The electrocaloric multilayer element may be substantially shaped as a parallelepiped, preferably as a cuboid having more preferably rounded corners. The electrocaloric multilayer element may have a thickness (along the transverse direction), and preferably a width and a length (perpendicularly to the transverse direction). One or more cut-outs or recesses may be present on one or more faces of the (preferably cuboid) electrocaloric multilayer element, preferably a cut-out or recess is present on a single face of the (preferably cuboid) electrocaloric multilayer element.

The thickness of the electrocaloric multilayer element may range from 10 µm to 1000 µm, preferably from 25 µm to 500 µm and more preferably from 50 µm to 250 µm.

The width of the electrocaloric multilayer element may range from 5 mm to 200 mm, preferably from 10 mm to 100 mm, and more preferably from 15 mm to 50 mm.

The length of the electrocaloric multilayer element may range from 5 mm to 200 mm, preferably from 10 mm to 100 mm, and more preferably from 15 mm to 50 mm.

The electrocaloric multilayer element may comprise an upper face, a lower face and a number of lateral faces, preferably four lateral faces. The upper face and lower face may be oriented perpendicularly to the transverse direction, while the lateral faces may be perpendicular to the upper face and lower face, and thus may extend along the transverse direction. The thickness may be measured between the upper and lower faces, the width may be measured between two opposite lateral faces, and the length may be measured between two other opposite lateral faces.

Making reference by way of illustration only to Fig. 1, the upper face may be formed by the outermost polymer layer 16 and the lower face may be formed by the outermost polymer layer 15. The lower face may correspond to the electrocaloric polymer layer 12 of the first unit 14. The upper face may correspond to the electrocaloric polymer layer 12 of the last unit 14 (contrary to what is shown on Fig. 1).

The stack may comprise electrical contacts 17, 17'. An electrical contact is formed by electrically conductive material which is electrically connected to two or more of the electrode layers 14. At least one electrical contact 17, 17' may be formed on one lateral face of the stack.

More preferably, the stack may comprise two (for example only two) electrical contacts 17, 17'.

The electrical contacts 17, 17' may be in direct (physical) contact with the electrode layers, as illustrated in Fig. 1. However, this is not a preferred configuration.

Preferably, as will be described in more detail below with reference to Fig. 2 to 5, the electrical contacts may be arranged remotely from the electrode layers and may be electrically connected to the electrode layers *via* respective leads.

Going back to the configuration illustrated in Fig. 1, the two electrical contacts 17, 17' may be formed on different lateral faces, preferably non-adjacent lateral faces, most preferably opposite lateral faces. If the stack comprises four lateral faces, two conductive lateral faces may alternate with two non-conductive lateral faces. A conductive lateral face may comprise an electrical contact 17, 17', while a non-conductive lateral face does not comprise an electrical contact.

The conductive lateral faces may be arranged across the width of the stack. Alternatively, the conductive lateral faces may be arranged across the length of the stack.

A non-conductive lateral face may act as a protective layer towards fluids, for example water. It may be formed by the electrocaloric polymer layers 12 of the various units 14 together with (or including) the outermost polymer layers 15, 16.

An electrically insulating material can be applied onto the conductive lateral faces (i.e. on top of the electrical contacts), to facilitate the use of the electrocaloric multilayer element in a liquid environment.

When two electrical contacts 17, 17' are present, a first electrical contact 17 may be connected to a first set of electrode layers 18, and a second electrical contact 17' may be connected to a second set of electrode layers 19. The electrode layers 13 of the first set 18 and second set 19 may alternate in the stack. In other words, the electrode layer 13 of the first unit 1 belongs to the first set 18, the electrode layer 13 of the second unit 2 belongs to the second set 19, the electrode layer 13 of the third unit 3 belongs to the first 18 set, etc. until the electrode layer 13 of the last unit n.

The electrode layers 13 of the first set 18 may all have the same shape and may all cover the respective electrocaloric polymer layers 12 of their units in the same manner. In other words, the outer perimeter of these electrode layers 13 may be aligned along the transverse direction 11. Similarly, the electrode layers 13 of the second set 19 may all have the same shape and may all cover the respective electrocaloric polymer layers 12 of their units in the same manner. In other words, the outer perimeter of these electrode layers may be aligned along the transverse direction. The electrode layers 13 of the first set 18 may have a different shape from the electrode layers 13 of the second set 19. In other words, the outer perimeter of the electrode layers 13 of the first set 18 may be unaligned with the outer perimeter of the electrode layers 13 of the second set 19 along the transverse direction.

All electrode layers 13 of the first set 18 may extend to one lateral face so as to be electrically connected to the first electrical contact 17 present on this lateral face; and may not extend to the (preferably opposite) lateral face comprising the second electrical contact 17', more preferably may not extend to any other lateral face.

Similarly, all electrode layers 13 of the second set 19 may extend to one lateral face so as to be electrically connected to the second electrical contact 17' present on this lateral face; and may not extend to the (preferably opposite) lateral face comprising the first electrical contact 17, more preferably may not extend to any other lateral face.

Therefore, the electrode layers 13 within the stack may be staggered, i.e. electrode layers 13 extending to one lateral face may alternate with electrode layers 13 extending to another (preferably opposite) lateral face.

When the electrocaloric multilayer element is in use, the first set 18 of electrodes may be at a different electric potential from the second set 19 of electrodes.

Making primarily reference to Fig. 2 to 5, a more preferred variation is now described. The entire description made in connection with Fig. 1 also applies to this more preferred variation, unless otherwise mentioned. In this more preferred variation, both (or all) electrical contacts may be present on a same lateral face.

As shown in Fig. 2, the electrocaloric multilayer element 10 may comprise one or more stacks, such as a first stack 51, a second stack 54 and a third stack 57 as illustrated. The electrocaloric multilayer could also comprise more than three stacks, arranged for example along a single row, or as an array of multiple rows and columns. Some of the stacks, possibly all of the stacks, may be electrically connected.

Adjacent stacks may be formed as an integral element, wherein the electrocaloric polymer layers are continuous from one stack to the next, i.e., for all units, the electrocaloric polymer layer of the i^{th} unit of one stack is integral with the electrocaloric polymer layer of the i^{th} unit of the next stack (for each integer i from 1 to n, n being the total number of units); while the electrode layers are discontinuous, i.e., for all units, the electrode layer of the i^{th} unit of one stack is physically separate from the electrode layer of the i^{th} unit of the next stack. The outermost polymer layer of one stack may also be integral with the corresponding outermost polymer layer of the next stack. As shown in Fig. 2, the electrocaloric multilayer element 10 may comprise a plurality of first leads 53 and a plurality of second leads 53', the first leads 53 being electrically connected to a first electrical contact 17, and the second leads 53' being electrically connected to a second electrical contact 17'.

By *"lead"* is meant a strip of electrically conductive material. Each lead electrically connects an electrode layer to a respective electrical contact. The strip may extend along a straight, curved and/or segmented line and may have a width (perpendicular to the thickness and to the direction of the straight, curved and/or segmented line) from 0.1 mm to 10 mm, preferably from 0.5 mm to 2 mm.

When more than two electrical contacts are present (as described above), each electrical contact may be associated with a respective set of leads, ensuring an electrical connection with a respective set of electrode layers. Otherwise, as illustrated in Fig. 2 to 5, only two electrical contacts 17, 17' may be present, each ensuring an electrical connection with a respective set 18, 19 of electrode layers.

The leads may be integrally formed with the respective electrode layer(s) that they are associated with, and may be made of the same electrically conductive material. When the electrode layers are deposited on respective electrocaloric polymer layers (to form respective units), the corresponding leads may be deposited together with the electrode layers. Alternatively, the leads may be deposited in a step separate from the step of depositing the electrode layers.

In some embodiments, when the electrocaloric multilayer element comprises two or more stacks, the electrode layers in each stack are electrically connected to different sets of first leads and second leads, i.e. there are different sets of leads per stack.

In other embodiments (as illustrated in Fig. 2 to 5), when the electrocaloric multilayer element comprises two or more stacks, the same leads, for example a same set of first leads and a same set of second leads, may be electrically connected to the electrode layers of a plurality of stacks, possibly of all of the stacks.

For example, as shown in Fig. 2, at least a set of first leads 53 and a set of second leads 53' may be present, wherein: each first lead 53 electrically connects an electrode layer of a first set 18 of electrode layers in the first stack 51, an electrode layer of a first set 18 of electrode layers in the second stack 54 and an electrode layer of a first set 18 of electrode layers in the third stack 57; and each second lead 53' electrically connects an electrode layer of a second set 19 of electrode layers in the first stack 51, an electrode layer of a second set 19 of electrode layers in the second stack 54 and an electrode layer of a second set 19 of electrode layers in the third stack 57. The first set 18 of electrode layers is different from the second set 19 of electrode layers, as described above. Each lead 53, 53' may comprise a terminal extension 59, 59' which extends away from the stacks 51, 54, 57 and be electrically connected to an electrical contact 17, 17'. All leads 53 of the first set may be connected to a first electrical contact 17 via their terminal extensions 59 and all leads 53' of the second set may be connected to a second electrical contact 17' via their terminal extensions 59'.

As illustrated in Fig. 2, the plurality of stacks 51, 54, 57 may be aligned in a row (in non-illustrated variants, the plurality of stacks may be aligned in an array of rows and columns). The first leads 53 and second leads 53' may comprise terminal extensions 59, 59' running along the direction of the row, leading to a lateral face 55 of the electrocaloric multilayer element. A cut-out or recess 52 may be present on this lateral face 55 between the terminal extensions 59 of the set of first leads 53 and the terminal extensions 59' of the set of second leads 53'. This may reduce the risk of an accidental short circuit between the corresponding first electrical contact and second electrical contact 17, 17'.

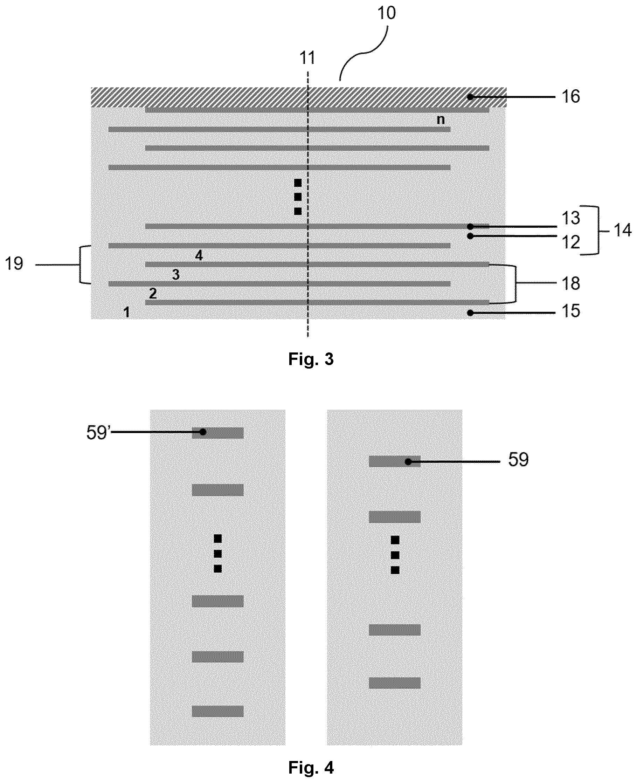

As illustrated in Fig. 2 and 3, the electrode layers of the electrocaloric multilayer element may be fully encapsulated in polymer material from the electrocaloric polymer layers and optionally the first and/or second outermost polymer layers (if distinct from the electrocaloric polymer layers). In other words, and contrary to what is shown in Fig. 1, the electrode layers do not extend to any lateral face of the electrocaloric multilayer element.

The electrode layers 13 within the stack may be staggered. The distance between a first lateral face and the electrode layers 13 of the first set 18 may be less than the distance between this first lateral face and the electrode layers 13 of the second set 19; whereas the distance between a second lateral face and the electrode layers 13 of the first set 18 may be less than the distance between this second lateral face and the electrode layers 13 of the second set 19. The first lateral face is preferably opposite the second lateral face. The lateral face 55 on which the electrical contacts 17, 17' are present may be different from these first lateral face and second lateral face.

All leads 53, 53' are also preferably fully encapsulated in polymer material from the electrocaloric polymer layers and optionally the first and/or second outermost polymer layers (if distinct from the electrocaloric polymer layers), except preferably for one extremity of each terminal extension 59, 59', which is connected to one electrical contact 17, 17'. This facilitates the use the electrocaloric multilayer element directly in a liquid environment, for example a water-based environment. The electrical contacts, as they are remote from the stacks, can then be easily placed in a sealed environment, i.e. can be physically separate from the liquid environment.

Thus, in use, the external faces or the electrocaloric multilayer element may be in contact with liquid, such as a heat transfer liquid (e.g., water), except for the face on which the electrical contacts 17, 17' are present.

In other variations, the (or each) stack may comprise units which do not all have the same orientation (i.e. the second face of the electrode layer of some units is oriented towards one outermost polymer layer; and the second face of the electrode layer of other units is oriented towards the other outermost polymer layer).

The (or each) stack may also comprise more than two sets of electrode layers, each set being connected to one electrical contact.

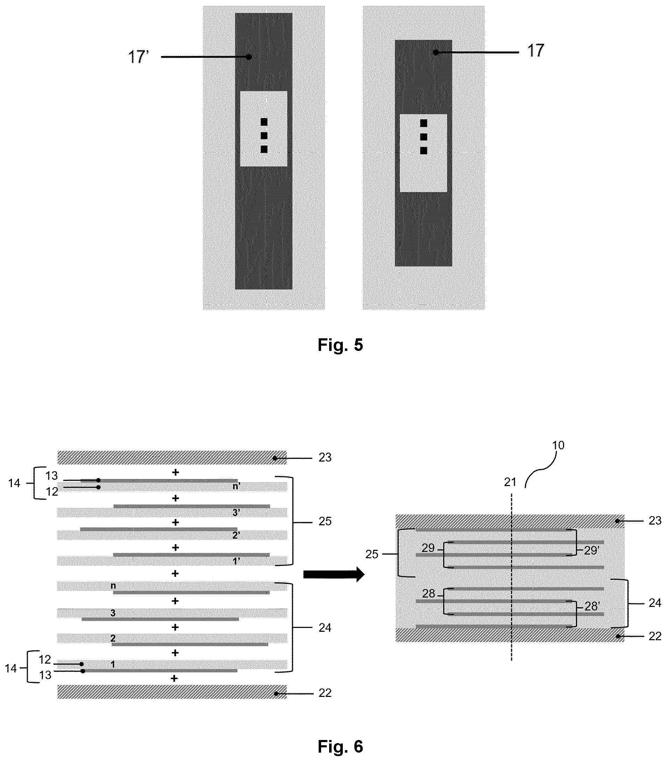

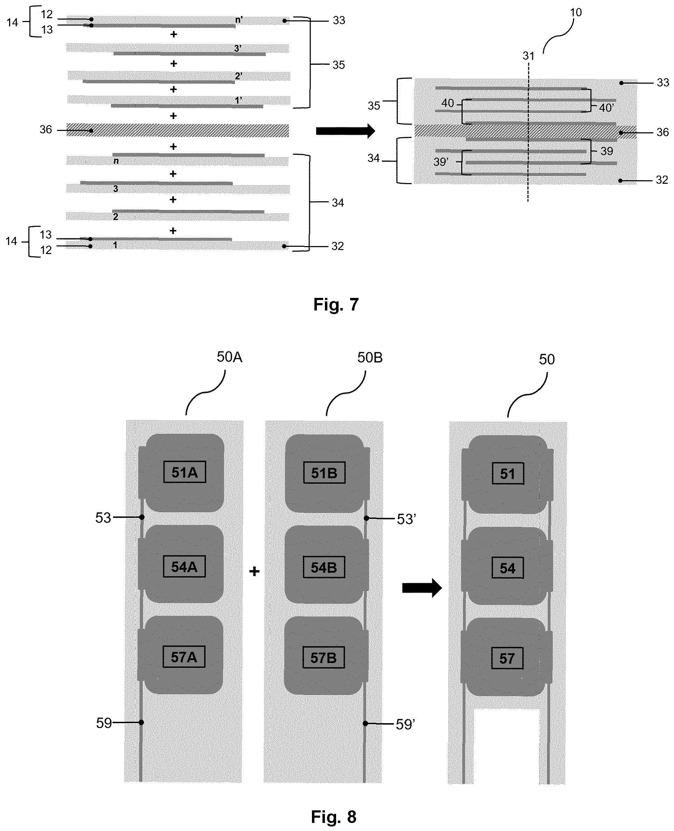

Fig. 6 and 7 provide an illustration of such variations. In both cases, the stack comprises two groups of units, namely a first group having a first orientation (the second face of each electrode layer being oriented towards one outermost polymer layer) and a second group having a second orientation (the second face of each electrode layer being oriented towards the other outermost polymer layer).

Making reference by way of illustration to Fig. 6 (wherein, unless otherwise specified, the above description, in particular with reference to Fig. 1 to 5, still applies), the (or each) stack may successively comprise, from one end of the stack to the opposite end of the stack: the first outermost polymer layer 22, a first group 24 of units 14 (labeled as 1, 2, 3, ..., n), a second group 25 of units 14 (labeled as 1', 2', 3',... n'), and the second outermost polymer layer 23.

The first group 24 of units 14 may have a different orientation from the second group 25 of units 14, as defined above.

The first outermost polymer layer 22 and the second outermost polymer layer 23 may be distinct from all units 14.

The number of units 14 in the first group 24 and second group 25 may be the same or different, preferably the same.

The first unit 14 of the first group 24 (labeled as 1) may have an electrode layer 13 in contact with the first outermost polymer layer 22.

The last unit 14 of the second group 25 (labeled as n') may have an electrode layer 13 in contact with the second outermost polymer layer 23.

The electrocaloric polymer layer of the last unit 14 of the first group 24 (labeled as n) may be joined (or fused) with the electrocaloric polymer layer of the first unit 14 of the second group 25 (labeled as 1'). That is, these two electrocaloric polymer layers may have been laminated into a single electrocaloric polymer layer in the manufacturing process.

Within the first group 24, two sets 28, 28' of electrode layers 13 may be present. The first set 28 of electrode layers 13 may be connected to a first electrical contact and the second set 28' of electrode layers 13 may be connected to a second electrical contact.

Within the second group 25, two sets 29, 29' of electrode layers 13 may be present. The first set 29 of electrode layers 13 may be connected to a first electrical contact and the second set 29' of electrode layers may be connected to a second electrical contact. Thus, the electrocaloric multilayer element 10 may comprise four electrical contacts. These four electrical contacts may be present on two opposite lateral faces of the electrocaloric multilayer element similarly to what is shown in in Fig. 1.

Alternatively, and preferably, the first electrical contact for the first group 24 may be the same as the first electrical contact for the second group 25, while the second electrical contact for the first group 24 may be the same as the second electrical contact for the second group 25. The two electrical contacts (not shown) may be present on a same lateral face of the electrocaloric multilayer element, and leads (including possibly terminal extensions) may extend between the electrode layers and their respective electrical contacts, as described above in connection with Fig. 2 to 5.

Thus, the electrode layers of the electrocaloric multilayer element (as well as the leads) may be fully encapsulated in polymer material from the electrocaloric polymer layers and the first and second outermost polymer layers, as shown on Fig. 6.

Within each group, the electrode layers of the first set and second set may alternate and/or be staggered exactly in the same manner as described above.

Making next reference by way of illustration to Fig. 7 (wherein, unless otherwise specified, the above description, in particular with reference to Fig. 1 to 6, still applies), the stack may successively comprise, from one end of the stack to the opposite end of the stack: a first group 34 of units 14 (labeled as 1, 2, 3, ..., n), an intermediate polymer layer 36 and a second group 35 of units 14 (labeled as 1', 2', 3', ... n').

The first group 34 of units 14 may have a different orientation from the second group 35 of units 14, as defined above.

The first outermost polymer layer 32 may be formed by the electrocaloric polymer layer 12 of the first unit of the first group 34, labeled as 1.

The second outermost polymer layer 33 may be formed by the electrocaloric polymer layer 12 of the last unit of the second group 35, labeled as n'.

The last unit 14 of the first group 34 (labeled as n) may have an electrode layer 13 in contact with the intermediate polymer layer 36.

The first unit 14 of the second group 35 (labeled as 1') may have an electrode layer 13 in contact with the intermediate polymer layer 36.

Within the first group 34, two sets 39, 39' of electrode layers 13 may be present. The first set 39 of electrode layers 13 may be connected to a first electrical contact and the second set 39' of electrode layers 13 may be connected to a second electrical contact.

Within the second group 35, two sets 40, 40' of electrode layers 13 may be present. The first set 40 of electrode layers 13 may be connected to a first electrical contact and the second set 40' of electrode layers 13 may be connected to a second electrical contact.

Thus, the electrocaloric multilayer element 10 may comprise four electrical contacts. These four electrical contacts may be present on two opposite lateral faces of the electrocaloric multilayer element similarly to what is shown in in Fig. 1.

Alternatively, and preferably, the first electrical contact for the first group 34 may be the same as the first electrical contact for the second group 35, while the second electrical contact for the first group 34 may be the same as the second electrical contact for the second group 35. The two electrical contacts (not shown) may be present on a same lateral face of the electrocaloric multilayer element, and leads (including possibly terminal extensions) may extend between the electrode layers and their respective electrical contacts, as described above in connection with Fig. 2 to 5.

Thus, the electrode layers of the electrocaloric multilayer element (as well as the leads) may be fully encapsulated in polymer material from the electrocaloric polymer layers and the intermediate polymer layer, as shown on Fig. 7.

Within each group, the electrode layers of the first set and second set may alternate and/or be staggered exactly in the same manner as described above.

In all of the above configurations, when there are two sets of electrode layers, the first set and the second set of electrode layers may be configured to be electrically connected to opposite electrical terminals of a power source. The power source is preferably external to the electrocaloric multilayer element. One of the electrical terminals may be at ground potential. One electrical terminal may be electrically connected to the first electrical contacts, the set of first leads and thus a corresponding first set of electrode layers. The other electrical terminal may be electrically connected to the second electrical contacts, the set of second leads and thus the second set of electrode layers. When there are more than two sets of electrode layers, sets of leads, and corresponding electrical contacts, some of the sets of electrode layers, corresponding sets of leads, and corresponding electrical contacts may be connected to one electrical terminal, while the other sets of electrode layers, corresponding sets of leads, and corresponding electrical contacts may be connected to the other electrical terminal.

Each stack of the electrocaloric polymer element 10 according to the invention may comprise a plurality of units, the number of units being from 2 to 100, preferably from 5 to 75 and more preferably from 10 to 50.

Each stack in the electrocaloric multilayer element 10 may have an active mass percentage from 50 to 55%, from 55 to 60%, from 60 to 65%, from 65 to 70%, from 70 to 75%, from 75 to 80%, from 85 to 90%, from 90 to 95%, or from 95 to 99%, relative to the total mass of the electrocaloric multilayer element.

By "active mass" is meant the amount of material composing the stack which is involved in the electrocaloric effect. The term "active mass" thus relates to the amount or mass of the electrocaloric polymer layers comprised between two adjacent electrode layers which, in use, have different potentials. The "inactive mass" comprises the mass of all electrically conductive material (including the electrode layers, leads and electrical contacts), as well as the mass of all polymer layers not comprised between two adjacent electrode layers which, in use, have different potentials (including, notably the first outermost polymer layer and second outermost polymer layer, as well as the portions of all electrocaloric polymer layers which are not between two adjacent electrode layers along the transverse direction). The total mass of the electrocaloric multilayer element is the sum of the active mass and of the inactive mass.

### Electrode layers

The electrode layers comprise an electrically conductive material, preferably a metal. Metal electrodes have better thermal and electrical conductivity compared to polymer and carbon nanotube electrodes. This allows to use thinner electrode layers that increase the active mass percentage while improving heat transfer within the electrocaloric multilayer element.

Each electrode layer may comprise a metal chosen among the group of transition metals; preferably the metal is aluminum, copper, nickel, magnesium, tungsten, molybdenum, manganese, titanium, vanadium, chromium, gold or platinum. Alloys comprising one or more of the above metals may also be used.

Preferably, all electrode layers in the electrocaloric multilayer element may be made of the same material.

Preferably, the electrode layers may comprise copper.

More preferably, the electrode layers may consist, or essentially consist of copper.

Each electrode layer may have an average thickness from 5 to 25 nm, from 25 to 50 nm, from 50 to 75 nm, from 75 to 100 nm, from 100 to 125 nm, from 125 to 150 nm, from 150 to 175 nm, from 175 to 200 nm, from 200 to 225 nm, from 225 to 250 nm, from 275 to 300 nm, from 300 to 325 nm, from 325 to 350 nm, from 350 to 375 nm, from 375 to 400 nm, from 400 to 425 nm, from 425 to 450 nm, from 450 to 475 nm, or from 475 to 500 nm.

Each electrode layer may have an average thickness from 10 to 500 nm, preferably from 20 to 400 nm and more preferably from 30 to 300 nm.

The thickness is measured according to the transverse direction.

All electrode layers in the electrocaloric multilayer element may have substantially the same thickness.

Each of the electrical contacts described above may be welds and/or conductive tapes and/or conductive pastes.

Welds may be made of a material selected from aluminum, copper, nickel, magnesium, tungsten, molybdenum, manganese, titanium, vanadium or chromium and alloys comprising these metals.

Conductive tapes may be carbon-based conductive tapes comprising a conductive glue/adhesive on one face or both faces of the tape. Conductive tapes may comprise a conductive metal (such as nickel, copper, aluminum, silver) and a non-conductive or a conductive adhesive.

Conductive pastes may comprise particles and/or fibers of a conductive metal or alloy, a solvent and a carrier substance. For example, silver paste may be used as a conductive paste.

When conductive stripes as mentioned above are used, they may be made of the same material as the electrode layers, which are described in more detail above.

As described above, the leads, when present, may be integrally formed with the electrode layers. Alternatively, the leads may be welds and/or conductive tapes and/or conductive pastes, as described above in connection with the electrical contacts.

Preferably, no adhesive is in contact with the electrode layers and leads. More preferably, no adhesive is in contact with the electrode layers, leads and electrical contacts.

### Electrocaloric polymer layers

The electrocaloric polymer layers comprise, preferably consist or essentially consist of, an electrocaloric polymer, i.e. a polymer which exhibits a measurable adiabatic temperature variation ΔT_{EC}, preferably of at least 1°C, when a variable electric field is applied at least one measurement temperature. Preferred electrocaloric properties of the polymer are described in more detail below.

Each electrocaloric polymer layer may have an average thickness from 0.5 to 2.5 µm, from 2.5 to 5 µm, from 5 to 7.5 µm, from 7.5 to 10 µm, from 10 to 12.5 µm, from 12.5 to 15 µm, from 15 to 17.5 µm, from 17.5 to 20 µm, from 20 to 22.5 µm, from 22.5 to 25 µm, from 25 to 27.5 µm, from 27.5 to 30 µm, from 30 to 32.5 µm, from 32.5 to 35 µm, from 35 to 37.5 µm, from 37.5 to 40 µm, from 40 to 42.5 µm, from 42.5 to 45 µm, from 45 to 47.5 µm, from 47.5 to 50 µm, from 50 to 52.5 µm, from 52.5 to 55 µm, from 55 to 57.5 µm, from 57.5 to 60 µm, from 60 to 62.5 µm, from 62.5 to 65 µm, from 65 to 67.5 µm, from 67.5 to 70 µm, from 70 to 72.5 µm, from 72.5 to 75 µm, from 75 to 77.5 µm, from 77.5 to 80 µm, from 80 to 82.5 µm, from 82.5 to 85 µm, from 85 to 87.5 µm, from 87.5 to 90 µm, from 90 to 92.5 µm, from 92.5 to 95 µm, from 95 to 97.5 µm, or from 97.5 to 100 µm.

Each electrocaloric polymer layer may have an average thickness from 0.5 to 100 µm, preferably from 1 to 90 µm, preferably from 1.5 to 75 µm and more preferably from 2 to 50 µm.

The plurality of electrocaloric polymer layers in the electrocaloric multilayer element may have substantially the same thickness.

The plurality of electrocaloric polymer layers in the electrocaloric multilayer element may have a different thickness.

The electrocaloric polymer is preferably a fluoropolymer, i.e. a polymer comprising fluorine atoms.

The fluoropolymer preferably comprises:
- a first repeat unit of formula -(CF₂-CH₂)-,
- optionally, a second repeat unit of formula -(CX₁X₂-CX₃X₄)-,
- optionally, a third repeat unit of formula -(CY₁Y₂-CY₃Z)-,
- optionally, a fourth repeat unit (referred to herein as DB) of formula -(CY₃=CF)-, -(CY₃=CX₁)-, -(CY₃=CX₂)-, -(CY₁=CY₃)- or -(CY₂=CY₃)-;
in which:
X₁ and X₂ are independently -H, -F, or an alkyl group comprising from 1 to 3 carbon atoms which is optionally partially or completely fluorinated,
X₃ and X₄ are independently -F or an alkyl group comprising from 1 to 3 carbon atoms which is optionally partially or completely fluorinated, except for the combination where: X₁ and X₂ are both: -H and X₃ and X₄ are both: -F,
Y₁ and Y₂ are independently -H, -F, -CI or an alkyl group comprising from 1 to 3 carbon atoms which is optionally partially or completely fluorinated,
Y₃ is -F, -Cl or an alkyl group comprising from 1 to 3 carbon atoms which is optionally partially or completely fluorinated,
Z is a halogen atom other than -F.

The fourth repeat unit DB may correspond to a combination of different units which all have a formula as mentioned above (-(CY₃=CF)-, -(CY₃=CX₁)-, -(CY₃=CX₂)-, -(CY₁=CY₃)-, -(CY₂=CY₃)-).

The fluoropolymer may most preferably be selected from the group of copolymers consisting of: copolymer P(VDF-TrFE), terpolymers P(VDF-TrFE-CTFE), P(VDF-TrFE-CFE) and P(VDF-TrFE-DB), quaterpolymers P(VDF-TrFE-CTFE-DB) and P(VDF-TrFE-CFE-DB), and combinations thereof, wherein VDF represents repeat units derived from vinylidene fluoride, TrFE represents repeat units derived from trifluoroethylene, CTFE represents repeat units derived from chlorotrifluoroethylene, CFE represents repeat units derived from 1,1- or 1,2-chlorofluoroethylene, and DB represents repeat units derived from -(CY₃=CF)-, -(CY₃=CX₁)-, -(CY₃=CX₂)-, -(CY₁=CY₃)- or -(CY₂=CY₃).

The fluoropolymer may essentially consist, or even solely consist, of the first repeat unit described above. Alternatively, the fluoropolymer may essentially consist, or even solely consist, of the first and second repeat units described above. Alternatively, the fluoropolymer may essentially consist, or even solely consist, of the first and third repeat units described above. Alternatively, the fluoropolymer may essentially consist, or even solely consist, of the first, second, and third repeat units described above. Alternatively, the fluoropolymer may essentially consist, or even solely consist, of the first, second and fourth repeat unit described above. Alternatively, the fluoropolymer may essentially consist, or even solely consist, of the first, third and fourth repeat unit described above. Alternatively, the fluoropolymer may essentially consist, or even solely consist, of the first, second, third and fourth repeat unit described above.

Alternatively, the fluoropolymer may include one or more additional units other than the first, second, third and fourth repeat units.

The first repeat unit originates from VDF.

The fluoropolymer may comprise a single second repeat unit or, on the contrary, several different second repeat units. Preferably, the second repeat unit/units may result from monomeric unit(s) chosen from the list consisting of: trifluoroethylene (TrFE), tetrafluoroethylene (TFE), hexafluoropropylene (HFP), trifluoropropenes and in particular 3,3,3-trifluoropropene, tetrafluoropropenes and in particular 2,3,3,3-tetrafluoropropene or 1,3,3,3-tetrafluoropropene, hexafluoroisobutylene, perfluorobutylethylene and pentafluoropropenes and in particular 1,1,3,3,3-pentafluoropropene or 1,2,3,3,3-pentafluoropropene. The fluoropolymer may comprise several second repeat units resulting from several different fluoromonomers.

X₁ may be: -H or -F; and X₂ , X₃ and X₄ may be, all three: -F. In other words, the second repeat unit can result from trifluoroethylene (TrFE) and/or from tetrafluoroethylene (TFE).

In some embodiments, the fluoropolymer may comprise a single second repeat unit resulting from the polymerization of trifluoroethylene.

Z may be -Cl, -Br or -I, preferably Z may be -Cl.

The fluoropolymer may comprise a single third repeat unit or, on the contrary, several different third repeat units. Preferably, the third repeat unit/units may result from monomeric unit(s) chosen from the list consisting of: 1,1-chlorofluoroethylene (1,1-CFE), 1,2-chlorofluoroethylene (1,2-CFE), chlorotrifluoroethylene (CTFE), 2-chloro-3,3,3-trifluoropropene (1233xf), 1-chloro-3,3,3-trifluoropropene (1233zd), 1,2-dichloro-1,2-difluoroethylene, 1,1-dichloro-1,1 -difluoroethylene and 1,1,2- trichloro-2-fluoroethylene.

Y₃ may be: -F, and Y₁ and Y₂ can both denote: -H or -F. In other words, according to these embodiments, the polymer can comprise units resulting from 1,1-CFE and/or CTFE.

In particular, the polymer can comprise units resulting from vinylidene fluoride (VDF), TrFE and CFE, or comprise units resulting from VDF, TrFE and CTFE, or comprise units resulting from VDF, TrFE, CFE and CTFE, or comprise units resulting from VDF, TFE and CFE, or comprise units resulting from VDF, TFE and CTFE, or comprise units resulting from VDF, TFE, CFE and CTFE, said polymers possibly additionally comprising carbon-carbon double bonds. The polymers of the above list can moreover comprise units resulting from one or more additional monomers, such as, for example, units resulting from HFP.

The fluoropolymer may comprise:
- from 30 to 100 mol. % of the first repeat unit,
- from 0 to 60 mol.% of the second repeat unit,
- from 0 to 20 mol.% of the third repeat unit,
- from 0 to 20 mol.% of the fourth repeat unit.

Preferably, the fluoropolymer may comprise:
- from 30 to less than 100 mol. % of the first repeat unit,
- from 0 to 60 mol.% of the second repeat unit,
- from more than 0 to 20 mol.% of the third repeat unit,
- from more than 0 to 20 mol.% of fourth repeat unit.

Even more preferably, the fluoropolymer may comprise:
- from 30 to 90 mol.% of the first repeat unit,
- from 0 to 60 mol.% of the second repeat unit,
- from more than 0 to 20 mol.% of the third repeat unit,
- from more than 0 to 20 mol.% of fourth repeat unit.

It is understood that when multiple second units or multiple third units or multiple fourth units are present, the stated contents correspond to the total of all second units, respectively, of all third units, respectively, of all fourth units.

The fluoropolymer may comprise from 30 to 35 mol.%, from 35 to 40 mol.%, from 40 to 45 mol.%, from 45 to 50 mol.%, from 50 to 55 mol.%, from 55 to 60 mol.%, from 60 to 65 mol.%, from 65 to 70 mol.%, from 70 to 75 mol.%, from 75 to 80 mol.%, from 80 to 85 mol.%, from 85 to 90 mol.%, from 90 to 95 mol.% or from 95 to less than 100 mol.%, or even 100 mol.% of the first repeat unit.

The fluoropolymer may comprise from 0 to 5 mol.%, from 5 to 10 mol.%, from 10 to 15 mol. %, from 15 to 20 mol. %, from 20 to 25 mol. %, from 25 to 30 mol.%, from 30 to 35 mol.%, from 35 to 40 mol.%, from 40 to 45 mol.%, from 45 % 50 mol.%, from 50 to 55 mol.%, or from 55 to 60 mol.% of the second repeat unit.

The fluoropolymer may comprise 0 mol.%, or from more than 0 to 1 mol.%, from 1 to 5 mol.%, from 5 to 10 mol.%, from 10 to 15 mol.%, or from 15 to 20 mol.% of the third repeat unit.

The fluoropolymer may comprise from 0.1 to 0.2 mol.%, from 0.2 to 0.3 mol.%, from 0.3 to 0.5 mol.%, from 0.5 to 1 mol.% molar, from 1 to 2 mol.%, from 2 to 3 mol.%, from 3 to 4 mol.%, from 4 to 5 mol.%, from 5 to 6 mol.%, from 6 to 7 mol.%, from 7 to 8 mol.%, from 8 to 9 mol.%, from 9 to 10 mol.%, from 10 to 12 mol.%, from 12 to 14 mol.%, from 14 to 16 mol.%, or from 16 to 18 mol.%, or from 18 to 20 mol.% of the fourth repeat unit.

Preferred contents for the fluoropolymer are as follows:
- from 40 to 80 mol.% of the first repeat unit, from 15 to 50 mol.% of the second repeat unit, and from 1 to 20 mol.% molar of the total of the third repeat unit and optionally fourth repeat unit;
- from 50 to 70 mol.% of the first repeat unit, from 20 to 40 mol.% of the second repeat unit, and from 3 to 15 mol.% of the total of the third repeat unit and optionally fourth repeat unit;
- from 55 to 65 mol.% molar of the first repeat unit, from 27 to 37 mol.% of the second repeat unit, and from 5 to 12 mol.% of the total of the third repeat unit and optionally fourth repeat unit;
- from 40 to 80 mol.% of the first repeat unit, from 15 to 50 mol.% of the second repeat unit, and from 1 to 20 mol.% molar of the total of the fourth repeat unit and optionally third repeat unit;
- from 50 to 70 mol.% of the first repeat unit, from 20 to 40 mol.% of the second repeat unit, and from 3 to 15 mol.% of the total of the fourth repeat unit and optionally third repeat unit;
- from 55 to 65 mol.% molar of the first repeat unit, from 27 to 37 mol.% of the second repeat unit, and from 5 to 12 mol.% of the total of the fourth repeat unit and optionally third repeat unit.

These contents apply in particular to polymers of the type P(VDF-TrFE-CTFE), P(VDF-TrFE-CFE), P(VDF-TFE-CTFE), P(VDF-TFE-CFE), P(VDF-TrFE-DB), P(VDF-TFE-DB), P(VDF-TrFE-CTFE-DB), P(VDF-TrFE-CFE-DB), P(VDF-TFE-CTFE-DB) or P(VDF-TFE-CFE-DB)

The molar composition of the repeat units in the fluoropolymers can be determined by various means, such as infrared spectroscopy or Raman spectroscopy. Conventional methods of elemental analysis of elements carbon, fluorine and chlorine or bromine or iodine, such as X-ray fluorescence spectroscopy, make it possible to unambiguously calculate the composition by weight of the polymers, from which the molar composition is deduced. Use may also be made of multinuclear, in particular proton (¹H) and fluorine (¹⁹ F), NMR techniques, by analysis of a solution of the polymer in an appropriate deuterated solvent. The NMR spectrum is recorded on an FT-NMR spectrometer equipped with a multinuclear probe. The specific signals given by the various monomers in the spectra produced according to one or the other nucleus are then located. Thus, for example, the unit resulting from the polymerization of VDF gives, in proton NMR, a specific signal for the -CH₂-groups (broad unresolved peak centered at 3 ppm). Likewise, the unit resulting from TrFE gives, in proton NMR, a specific signal characteristic of the -CFH-group (at approximately 5 ppm). In fluorine NMR, the signals resulting from the -CF₂- and -CFCI- units of CFE and CTFE are combined with those of the -CF₂-units of VDF and TrFE between -90 and -132 ppm. The -CHF- unit of TrFE gives characteristic signals between -194 and -220 ppm. The combination of the proton and fluorine NMR spectra makes it possible to unambiguously deduce the molar composition of the polymers.

The presence of double bonds in the fluoropolymers can be evaluated by different spectroscopic methods and in particular Raman spectroscopy. The valence vibration band at 1720 cm⁻¹ corresponds to the presence of a single type of C=C double bond, attributable to -CF=CH- bonds. Conjugated double bonds are observed by valence vibration bands which are wider and at lower wavenumbers, between 1500 and 1700 cm⁻¹. The presence of double bonds can be quantified by proton NMR by virtue of the appearance of signals between 6.0 and 6.7 ppm.

The electrocaloric polymer can be a ferroelectric polymer. "Conventional ferroelectric" polymers, often simply denoted as "ferroelectrics", such as of the P(VDF-TrFE) type, are characterized by a broad hysteresis loop of the electric displacement-applied electric field curve. For these materials, this loop is characterized by a high coercive field at 25°C, typically greater in absolute value than 45 V/µm, and a high remanent polarization at 25°C, typically of greater than 50 mC/m². These materials have a maximum of their electrocaloric properties at temperatures close to their Curie temperature. At this temperature, a ferroelectric -+ paraelectric (FE -+ PE) crystal structure transition, takes place, corresponding to an abrupt depolarization of the macroscopic ferroelectric domains. This transition is narrow, of the first order, and is characterized by a narrow maximum of the dielectric permittivity, the position of which does not depend on the frequency of application of the electric field. The Curie temperature can be adjusted as a function of the composition of the polymer: the higher the proportion of vinylidene fluoride, the higher the Curie temperature. This temperature typically varies between 60°C and 150°C for molar percentages of vinylidene fluoride in the P(VDF-TrFE) copolymer of between 55 mol.% and 82 mol.%.

Advantageously, the electrocaloric polymer can be a relaxor ferroelectric. "Relaxor ferroelectric" polymers are characterized by a relaxor ferroelectric (RFE) -+ paraelectric (PE) transition over a wide range of temperatures. At the level of this transition, a broad peak of dielectric permittivity is observed, the temperature of this maximum depending on the frequency of the applied electric field: the lower the frequency of the electric field, the more the dielectric permittivity maximum is shifted toward low temperatures. At the temperatures of the RFE -+ PE transition or slightly greater temperatures, the application of an electric field makes it possible to generate and to align the polar nanoregions, inducing a variation in entropy, and thus a significant electrocaloric effect over a wide range of temperatures. Relaxor ferroelectric polymers are characterized at 25°C, and at a frequency of approximately 1 Hz, by a hysteresis loop of the "electric displacement" as a function of the "applied electric field" curve which is much finer than the hysteresis loop of a ferroelectric polymer. They typically have a coercive field of less than or equal in absolute value to 45 V/µm and a remanent polarization of less than or equal to 40 mC/m². According to some preferential embodiments, the electrocaloric polymer used in the invention can have a coercive field of less than or equal to 25 V/µm and a remanent polarization of less than or equal to 20 mC/m².

Relaxor ferroelectric polymers are generally obtained by introducing defects into the crystal structure of ferroelectric polymers, thus decreasing the size of the polar domains. This can, for example, be done by irradiating a conventional ferroelectric polymer. However, it is preferable to obtain a relaxor ferroelectric nature by the presence of units resulting from specific monomers, such as CFE or CTFE as described above. By comparison with conventional ferroelectric polymers, the phase transition corresponding to the dielectric permittivity maximum and/or to the ΔT_{EC} maximum can be obtained at lower temperature, in particular between 0°C and 100°C, and in some cases between 20°C and 60°C. Thus, relaxor ferroelectric polymers have advantageous electrocaloric properties, over a wide range of temperatures, and in particular at temperatures close to ambient temperature. They are therefore particularly advantageous for the production of electrocaloric devices.

The electrocaloric polymer used in the invention is advantageously random and linear. The polymer can be obtained according to processes known from the prior art. It can in particular be prepared by radical polymerization according to a solution, suspension, emulsion or microemulsion polymerization process.

The polymerization reaction is generally carried out in the presence of a radical initiator. The latter can, for example, be a tert-alkyl peroxyester, such as tert-butyl peroxypivalate (or TBPPI) or tert-amyl peroxypivalate, a peroxydicarbonate, such as bis(4-(tert-butyl)cyclohexyl) peroxydicarbonate, sodium, ammonium or potassium persulfate, benzoyl peroxide and its derivatives, a tert-alkyl hydroperoxide, such as tert-butyl hydroperoxide, a tert-alkyl peroxide, such as tert-butyl peroxide, or a tert-alkylperoxyalkane, such as 2,5-bis(tert-butylperoxy)-2,5-dimethylhexane. Alternatively or additionally, an azo initiator or a redox system can be used as radical initiator. The polymer can also be obtained by reduction of a copolymer of P(VDF-CTFE) type to give a copolymer of P(VDF-TrFE-CTFE) type (see: Wang et al., "High dielectric VDF/TrFE/CTFE terpolymers prepared by hydrogenation of VDF/CTFE copolymers: synthesis and characterization", Macromolecules, 39 (5), 4268-4271 (2006)).

The electrocaloric polymer may contain double bonds, notably if the fourth repeat unit described above is present in a fluoropolymer. The double bonds may be introduced in a fluoropolymer through a dehalogenation reaction using an inorganic or an organic base. This strategy is described in several documents, such as:
- WO 2019/075061 A1,
- US 4904739 A,
- Enhanced Electrocaloric Response of Vinylidene Fluoride-Based Polymers via One-Step Molecular Engineering (Le Goupil F. et al., Adv. Funct. Mater., 2021, 31, 1, 2007043,
- WO 2021/116618A1,
- WO 2019/020906 A1, and
- FR 2313936.

Advantageously, the polymer exhibits a variation in adiabatic temperature ΔT_{EC} of at least 1°C, at at least one measurement temperature, the measurements of variations in adiabatic temperatures being carried out at an electric field of given amplitude ΔE. The measurement temperature corresponds to the temperature to which the sample is brought before it is subjected to the variation in electric field ΔE causing the electrocaloric effect.

Preferably, the polymer exhibits a variation in adiabatic temperature ΔT_{EC} of at least 1.5°C, or of at least 2°C, or of at least 2.5°C, or of at least 3°C, or of at least 3.5°C, or of at least 4.0°C, or of at least 4.5°C, or of at least 5°C, or of at least 6°C, or of at least 7°C, or of at least 8°C, or of at least 9°C, or of at least 10°C, in a given variable field, at a given measurement temperature.

The electric field used to demonstrate an electrocaloric effect must be variable. This is because it is the variation in electric field which causes the electrocaloric effect.

Generally, the higher the amplitude of the electric field, the greater the electrocaloric effect. However, the maximum amplitude of the electric field must be appropriate so as not to reach the breakdown voltage of the polymer. In addition, the production of high voltages requires a specific appliance which is highly energy-consuming, which is not necessarily desirable. According to some embodiments, the electric field used to demonstrate a significant electrocaloric effect for a use as described below can have a maximum amplitude of less than or equal to 500 V/µm, or less than or equal to 400 V/µm, or less than or equal to 300 V/µm, or less than or equal to 200V/µm, or less than or equal to 150V/µm, or less than or equal to 140 V/µm, or less than or equal to 130 V/µm, or less than or equal to 120 V/µm, or less than or equal to 110V/ µm, or less than or equal to 100 V/µm, or less than or equal to 90 V/µm.

According to some embodiments, the electric field can have an amplitude of greater than or equal to 30 V/µm, or greater than or equal to 40 V/µm, or greater than or equal to 50 V/µm.

Preferably, the polymer has a dielectric strength of greater than or equal to 200 V/µm, preferentially of greater than or equal to 300 V/µm, more preferentially of greater than or equal to 400 V/µm and extremely preferably of greater than or equal to 500 V/µm. The dielectric strength can be measured according to the standard ASTM D3755-97.

An electric field of square-wave type, with a maximum value equal to ΔE and a minimum value equal to 0, can typically be used.

In order to properly measure ΔT_{EC}, the frequency of the electric field must be high enough to be in adiabatic conditions. Frequencies ranging from 1 mHz to 100 Hz, preferentially frequencies ranging from 0.1 Hz to 10 Hz, can be used.

The measurement temperature can be between the glass transition temperature and the melting point of the polymer. The term "glass transition temperature" is understood to denote the temperature at which an at least partially amorphous polymer changes from a rubbery state to a glassy state, or vice versa, as measured by differential scanning calorimetry (DSC) according to the standard ISO 11357-2: 2013, in second heating, using a heating rate of 10° C/min. The term "melting point" is understood to denote the temperature at which an at least partially crystalline polymer passes into the viscous liquid state, as measured by differential scanning calorimetry (DSC) according to the standard ISO 11357-3:2018, in second heating, using a heating rate of 10°C/min.

Thus, the measurement temperature can in particular be from -20°C to 150°C, preferentially from 0°C to 100°C, more preferentially from 15°C to 60°C and extremely preferably from 20°C to 40°C.

The polymer may have a relative dielectric permittivity of greater than or equal to 8, preferentially of greater than or equal to 10 preferentially of greater than or equal to 15, preferentially of greater than or equal to 20, more preferentially of greater than or equal to 40 and extremely preferentially of greater than or equal to 55, over a range of temperatures of at least 5°C, preferentially of at least 10°C, preferentially of at least 20°C and extremely preferentially of at least 30°C, said relative dielectric permittivity being measured at 1 kHz.

The polymer may have a permittivity maximum at a temperature of less than or equal to 60°C, preferably at a temperature of less than or equal to 50°C and more preferably at a temperature of less than or equal to 40°C, said relative dielectric permittivity being measured at 1 kHz.

The polymer may have a remanent polarization of less than or equal to 20 mC/m² and/or a coercive field of less than or equal to 25 V/µm, the remanent polarization and coercive field measurements both being carried out at a temperature of 25°C, at a frequency of 1 Hz and at a field of 150 V/µm.

The polymer may have a maximum polarization greater than or equal to 0.5 µC/cm², preferably greater than or equal to 1 µC/cm², preferably greater than or equal to 2 µC/cm², preferably greater than or equal to 3 µC/cm², preferably greater than or equal to 4 µC/cm², preferably greater than or equal to 5 µC/cm², preferably greater than or equal to 6 µC/cm², preferably greater than or equal to 7 µC/cm², preferably greater than or equal to 8 µC/cm², said maximum polarization being measured at a frequency of 1000 Hz, at 25°C, and under an electric field of 1300 kV/cm.

The polymer may have a coercive field preferably less than or equal to 2000 kV/cm, preferably less than or equal to 1500 kV/cm, preferably less than or equal to 1000 kV/cm, preferably less than or equal to 500 kV/cm, said coercive field being measured at a frequency of 100 Hz, at 25°C.

The polymer may have a remanent polarization preferably ranging from 0.1 to 5 µC/cm², preferably ranging from 0.15 to 2.5 µC/cm², preferably ranging from 0.3 to 0.6 µC/cm², said remanent polarization being measured at a frequency of 100 Hz, at 25°C, and under a field of 1300 kV/cm.

### Other polymer layers

The first outermost polymer layer, second outermost polymer layer and intermediate polymer layer (if present) may be made of a fluoropolymer. Preferably, the first outermost polymer layer and/or second outermost polymer layer may be made of the same polymer as the electrocaloric polymer layers.

In some embodiments, the first outermost polymer layer, second outermost polymer layer and intermediate polymer layer (if present) may be made of any polymer, such as a hydrophobic polymer.

The first outermost polymer layer and/or second outermost polymer layer may also be made of two or more sublayers, for example they can be in the form of a thin tape (comprising an adhesive polymer sublayer and a backing polymer sublayer).

Preferably, the first outermost polymer layer, second outermost polymer layer and intermediate polymer layer (if present) may be made of a polymer having substantially the same melting point as the polymer of the electrocaloric polymer layers (for example, the difference in melting points may be less than 10°C, or less than 5°C, or less than 2°C).

The first outermost polymer layer, second outermost polymer layer and intermediate polymer layer (if present) may have substantially the same thickness as the electrocaloric polymer layers.

The first outermost polymer layer, second outermost polymer layer and intermediate polymer layer (if present) may have a thickness that is greater by at least 5%, preferably by at least 10%, preferably by at least 15%, preferably by at least 25%, and more preferably by at least 25% compared to the thickness of the electrocaloric polymer layers.

### Process for making an electrocaloric multilayer element

The process for producing an electrocaloric multilayer element according to the invention may comprise assembling the layers to form the stack.

Preferably, the method comprises:
a) a step of preparing a plurality of units wherein each unit is made by depositing an electrode layer onto an electrocaloric polymer layer;
b) a step of assembling the plurality of units together.

At step b), the units may also be assembled together with the first outermost polymer layer (in case it does not belong to one of the units), the second outermost polymer layer (in case it does not belong to one of the units) and/or the intermediate polymer layer (if present).

Step a) may comprise the following sub-steps:
1) Casting molten electrocaloric polymer on a substrate plate, preferably by a bar-coating technique, to form a molten polymer layer.
2) Drying the molten polymer layer on the substrate, preferably at a temperature from 20°C to 30°C, preferably at atmospheric pressure for a duration from 5 to 60 minutes, preferably from 15 to 30 minutes.
3) Preferably, crystallizing the polymer layer on the substrate, preferably at a temperature which is lower than the melting point of the polymer by 1°C to 50°C, more preferably from 5 to 20°C, preferably at or below atmospheric pressure and preferably for a duration from 30 min to 1 day. The duration is preferably longer if the temperature is lower. Merely by way of example, crystallization may be carried out at a temperature from 130 to 150°C, such as approximately 140°C, and for a duration of 2 to 6 hours, such as approximately 4 hours, for a P(VDF-TrFE) polymer; and crystallization may be carried out at a temperature from 100 to 120°C, such as approximately 110°C, and for a duration of 8 to 16 hours, such as approximately 12 hours, for a P(VDF-TrFE-CFE) or P(VDF-TrFE-CTFE) polymer.
4) Removing the polymer layer from the substrate, thereby obtaining the electrocaloric polymer layer, in the form of a free-standing polymer film.
5) Depositing the electrode layer on the electrocaloric polymer layer, for example by vacuum deposition or by sputtering a metallic target on the electrocaloric polymer layer of sub-step 4).

The unit may be obtained directly at the end of 5). Alternatively, an optional sub-step 6) of cutting the obtained part into individual units may be provided.

Optionally, after step 5), the leads may also be deposited. However, preferably, the leads may be deposited simultaneously with (and integrally with) the electrode layers.

Step b) may comprise the following sub-steps:
1) Stacking the units upon each other, optionally together with the first and/or second outermost polymer layers (if not included in one of the units) and/or with the intermediate polymer (if present), which are preferably in the form of free-standing films, thereby obtaining a stack.
2) Performing thermal lamination, wherein preferably the stack is heated to a temperature of 2 to 5°C below the melting point of the polymers comprised in the stack (or the melting point of the electrocaloric polymer), for example for a duration of 15 minutes to 5 hours (e.g. 2 hours) and for example at a pressure of 0.05 to 2 bar, preferably from 0.1 to 1 bar. A pressure of less than 1 bar is believed to be advantageous in particular for terpolymers comprising a third repeat unit such as CTFE or CFE. The thermal lamination temperature must be high enough to ensure efficient bonding of the polymer layers to the electrode layers, while being below the melting point of the polymers so as not to compromise the uniformity of the multilayer structure. The thermal lamination provides a good adhesion of all layers involved in the stack thus having a uniform and homogeneous structure. This step allows the multilayer element to have a better mechanical stability without adhesives and a better dielectric strength. Since no adhesives are used, it also leads to an increase in the percentage of active mass.
3) Performing re-crystallization wherein preferably the stack is heated to a temperature of 2 to 20°C, more preferably 10 to 20°C, below the melting point of the polymers comprised in the stack (or the melting point of the electrocaloric polymer), for example for a duration of 4 to 12 hours. This step ensures a good crystallinity of the polymer phases which is favorable for electrocaloric performances.

After step b), the abovementioned electrical contacts can be electrically connected to the electrode layers. For example, the electrical contacts may be added by soldering, applying an electrically conductive tape, and/or applying an electrically conductive paste or electrically conductive epoxy adhesive.

Optionally, after step b), the process may comprise a step of applying a solution comprising a polymer ink and a solvent on the electrocaloric multilayer element (for example on at least part of the electrical contacts), evaporating said solvent thus generating a protective layer; and/or a step of cutting part of the electrocaloric multilayer element.

When the electrocaloric multilayer element comprises two or more stacks, these stacks may be prepared simultaneously. At step a), a unit comprising a single electrocaloric polymer layer comprising two or more deposits of electrode material (forming the electrode layers of different stacks), and preferably a lead, may be obtained. At step b), a plurality of such units may be assembled together, in order to obtain electrocaloric multilayer element having two or more stacks wherein the electrocaloric polymer layers are preferably continuous from one stack to the next, while the electrode layers are discontinuous.

Making reference to Fig. 1 or Fig. 3, an electrocaloric multilayer element 10 may be made by a) preparing n units 14 each comprising an electrode layer 13 deposited on an electrocaloric polymer layer 12, b) assembling the n units in the same orientation, the electrocaloric polymer layer 12 of unit number i being arranged on top of the electrode layer of unit number i-1, for each integer i from 2 to n, arranging a second outermost polymer layer 16 on top of the last unit number n, performing thermal lamination and re-crystallization as described above. The electrical contacts 17, 17' may be subsequently applied.

Making reference to Fig. 6, an electrocaloric multilayer element 10 may be made by a) preparing a first group of n units 14 each comprising an electrode layer 13 deposited on an electrocaloric polymer layer 12, and a second group of n' units 14 each comprising an electrode layer 13 deposited on an electrocaloric polymer layer 12, b) assembling the n units of the first group and the n' units of the second group, together with a first outermost polymer layer 22 and a second outermost polymer layer 23, the order of layers being as follows: first, the first outermost polymer layer 22, then the n units of the first group in one orientation, the electrode layer 13 of unit number 1 of the first group being arranged on top of the first outermost polymer layer 22 and the electrode layer 13 of each unit i of the first group being arranged on top of the electrocaloric polymer layer 12 of unit i-1 of the first group, for each integer i from 2 to n, then the n' units of the second group in an orientation opposite to the first orientation, the electrocaloric polymer layer 12 of unit number 1 being arranged on top of the electrocaloric polymer layer 12 of the last unit n of the first group, and the electrocaloric polymer layer 12 of each unit i of the second group being arranged on top of the electrode layer 13 of unit i-1 of the second group, for each integer i from 2 to n', and then the second outermost polymer layer 23 on top of the last unit number n' of the second group; performing thermal lamination and re-crystallization as described above. The electrical contacts may be subsequently applied.

Making reference to Fig. 7, an electrocaloric multilayer element 10 may be made by a) preparing a first group of n units 14 each comprising an electrode layer 13 deposited on an electrocaloric polymer layer 12, and a second group of n' units 14 each comprising an electrode layer 13 deposited on an electrocaloric polymer layer 12, b) assembling the n units of the first group and the n' units of the second group, together with an intermediate polymer layer 36, the order of layers being as follows: first, the n units of the first group in one orientation, the electrocaloric polymer layer 12 of each unit i in the first group being arranged on top of the electrode layer 13 of unit i-1 in the first group, for each integer i from 2 to n, then the intermediate polymer 36 on top of the electrode layer 13 of the last unit n of the first group, then the n' units of the second group in an orientation opposite to the orientation of the first group, the electrode layer 13 of unit number 1 of the second group being arranged on top of the intermediate polymer layer 36, and the electrode layer 13 of each unit i of the second group being arranged on top of the electrocaloric polymer layer 12 of unit i-1 of the second group, for each integer i from 2 to n'; performing thermal lamination and re-crystallization as described above. The electrical contacts may be subsequently applied.

The three above paragraphs are also applicable when the units comprise two or more electrode layers, so that the resulting electrocaloric multilayer element comprises two or more stacks.

Each unit may also comprise a lead as described above.

Within each succession of units in the stack, or within each succession of units in a group of units (preferably having a same orientation as described above) in the stack, units having a lead configured to be connected to a first electrical contact may alternate with units having a lead configured to be connected to a second electrical contact. The leads configured to be connected to a first electrical contact may for example be aligned when viewed from the transverse direction, the leads configured to be connected to a second electrical contact may for example be aligned when viewed from the transverse direction, while the leads configured to be connected to a first electrical contact may for example be unaligned with the leads configured to be connected to a second electrical contact when viewed from the transverse direction. For example, each unit may have a number of edges when viewed from the transverse direction, such as four edges if the shape is parallelepiped or preferably rectangular. In this case, the leads configured to be connected to a first electrical contact may be closer to one edge, while the leads configured to be connected to a second electrical contact may be closer to another edge, such as the edge opposite the one edge.

Fig. 8 shows an illustration of this situation. Within the stack, or within a group of units in the stack, units 50A of a first type alternate with units 50B of the second type. Each unit 50A of the first type may comprise one or more electrode layers 51A, 54A, 57A, and a lead 53 (optionally comprising a terminal extension 59) and each unit 50B of the second type may comprise one or more electrode layers 51B, 54B, 57B, and a lead 53' (optionally comprising a terminal extension 59'). The electrode layers 51A, 54A, 57A of the units of the first type may be aligned with the electrode layers 51B, 54B, 57B of the units of the second type, when stacked (and when viewed from the transverse direction). The leads 53 of the units of the first type may be aligned together, when stacked (and when viewed from the transverse direction). The leads 53' of the units of the second type may be aligned together, when stacked (and when viewed from the transverse direction). But the leads 53 of the units of the first type may be unaligned with the leads 53' of the units of the second type, when stacked (and when viewed from the transverse direction). The leads 53 of the units of the first type may be closer to one edge of the units or stack, while the leads 53' of the units of the second type may be closer to another, opposite edge of the units or stack. On the right-hand side of Fig. 8, the resulting assembly of units is schematically depicted (after cutting a recess or cut out on one of the lateral faces).

### EXAMPLES

### Example 1 - measurement of ferroelectric properties

Multilayer elements were made based on the process described above. Each multilayer element comprised 11 electrode layers made of copper having a thickness ranging from 50 nm to 150 nm and 12 electrocaloric polymer layers having a thickness of approximately 10 µm. The electrode layers alternated with the electrocaloric polymer layers. 10 electrocaloric polymer layers were comprised between adjacent electrode layers and were thus electroactive, the other two electrocaloric polymer layers at both ends of the stack had a support and encapsulation function (first and second outermost polymer layers). The surface area of the electrode layers perpendicular to the transverse direction was approximately 10 cm². Three different elements were made, using three different fluoropolymers (for all electrocaloric polymer layers):
- 20TrFE: P(VDF-TrFE) copolymer comprising 20 mol.% of TrFE units.
- 45TrFE: P(VDF-TrFE) copolymer comprising 45 mol.% of TrFE units.
- 31TrFE + 7CFE: P(VDF-TrFE-CFE) terpolymer comprising 31 mol.% of TrFE units and 7 mol.% of CFE (1,1-chlorofluoethylene) unit.

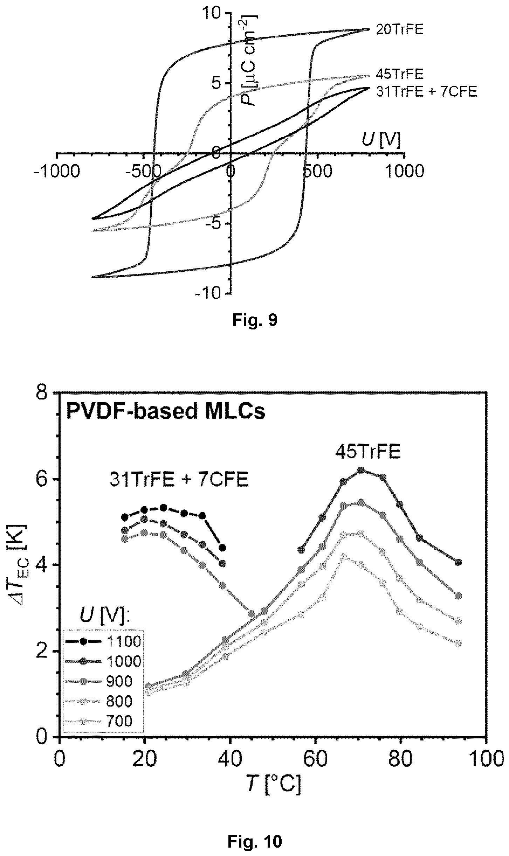

The ferroelectric properties of these elements were measured at 25°C. AC current density - electric filed (j-E) loops were measured with an Aixacct TF analyzer 2000E by applying a triangular waveform with a frequency of 1 Hz and a voltage up to 800 V. The polarization-electric field hysteresis loops were simultaneously determined with the Aixacct software by numerical integration of the current signal. The results are depicted in the graph of Fig. 9.

They show that the multilayer elements can withstand large electric fields and low leakage current. The samples based on 20TrFE and 45TrFE exhibit ferroelectric properties, while the sample based on 31TrFE + 7CFE exhibits relaxor ferroelectric properties.

### Example 2 - measurement of electrocaloric properties

The electrocaloric properties of the multilayer element samples 45TrFE and 31TrFE + 7CFE described in example 1 were investigated by applying an electric field of square-wave type at a frequency of 1 Hz and a maximum voltage of 700 to 1100 V, at various temperatures. The corresponding variation in adiabatic temperature ΔT_{EC} was measured based on the protocol described in Direct Electrocaloric Characterization of Ceramic Films, U. Prah et al., Small Methods, 7, 2300212 (2023). The direct measurement of the EC temperature change (ΔTεc) was performed using a commercially available IR camera (FLIR X6580sc) with a quantum InSb detector and forced cooling. The IR camera was pre-calibrated by the manufacturer. Due to the high thermal reflectivity of the top metal electrode, additional black ink (black matt, Colorjelt RAL 9005, Jelt) was used to bring the emissivity of the surface close to 1 and to allow accurate monitoring of the sample temperature. The measured EC temperature change was averaged over the selected ink-coated areas (assuming an emissivity of 1) and plotted as the mean value of several consecutive EC cooling peaks (only cooling peaks, i.e. temperature drop when the electric field is removed, were taken into account).

The results are depicted in Fig. 10. They show that the electrocaloric effect is maximal for 45TrFE at a temperature of approximately 65 to 70°C, whereas it is maximal for 31TrFE + 7CFE at a temperature of approximately 20 to 25°C. The electrocaloric effect measured here is remarkably large.

### Example 3 - measurement of ferroelectric properties

A multilayer element was made as described in Example 1, except that the electrocaloric polymer used was a terpolymer containing 62 mol.% of VDF units, 31 mol.% of TrFE units and 7 mol.% of CFE units, and that the multilayer elements comprised 2 × 4 layers, with gold electrode layers. The electrocaloric polymer layers had a thickness of approximately 10 µm. The surface area of the electrode layers perpendicular to the transverse direction was approximately 8 cm².

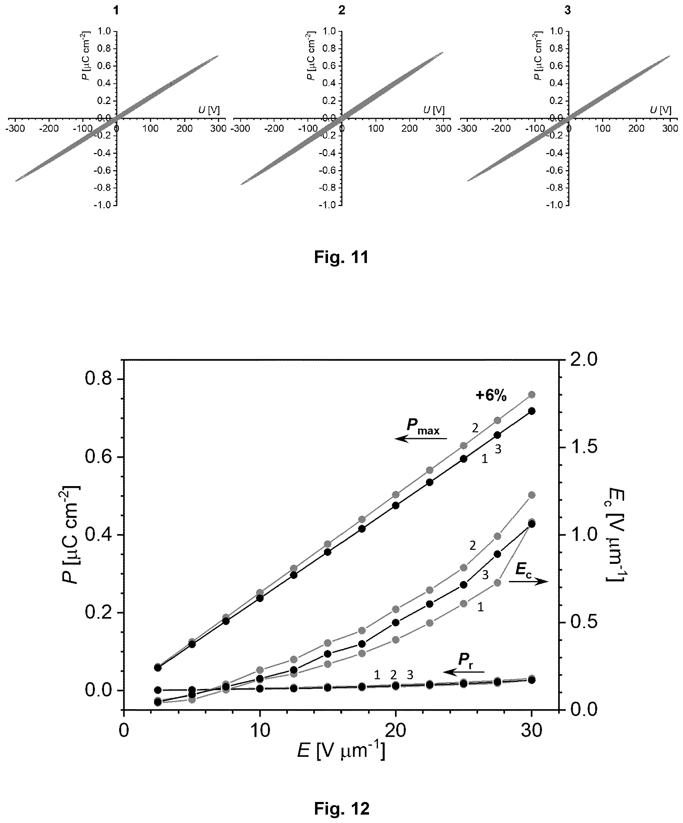

The polarization-electric field hysteresis loops were obtained as described above, first in air, then in deionized water, and then again in air. The results are shown in Fig. 11 (1: air, 2: deionized water, 3: air). Fig. 12 shows the maximum polarization Pₘₐₓ, the remanent polarization Pᵣ and coercive electric field E_{c}.

It can readily be seen that the polarization-electric field hysteresis loops in air and deionized water are nearly identical, which proves that the electrocaloric multilayer element was properly encapsulated. A slight increase of maximum polarization (-6%) and coercive electric field was observed.

### Example 4 - measurement of ferroelectric properties

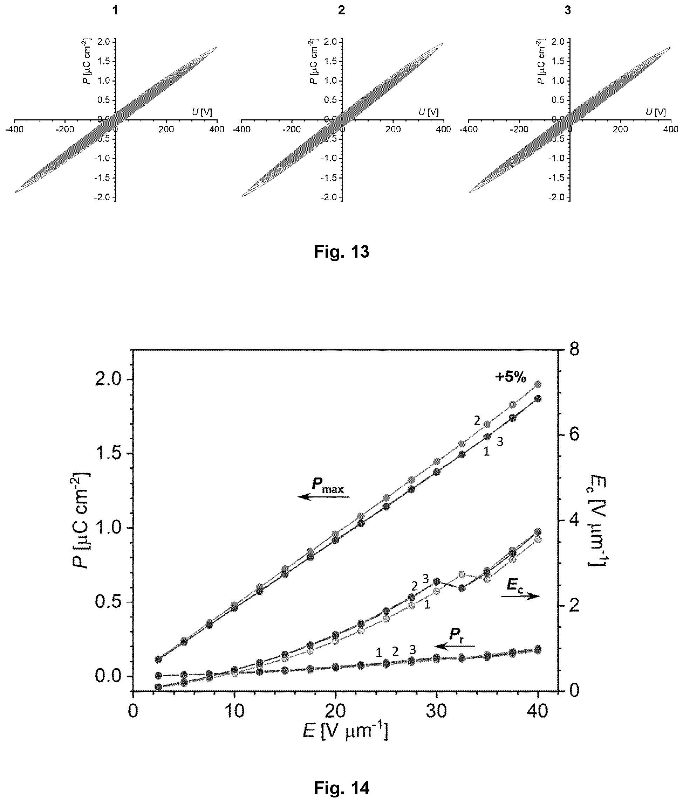

Another multilayer element was made exactly as described in Example 3 and was tested in the same manner, first in air, then in tap water, and then again in air. The results are shown in Fig. 13 (1: air, 2: tap water, 3: air). Fig. 14 shows the maximum polarization Pₘₐₓ, the remanent polarization Pᵣ and coercive electric field E_{c}.

It can readily be seen that the polarization-electric field hysteresis loops in air and tap water are nearly identical, which again proves that the electrocaloric multilayer element was properly encapsulated. A slight increase in maximum polarization (~5%) and coercive electric field was again observed, and is thus independent of the type of water. Despite the 2 to 3 orders of magnitude higher electrical conductivity of tap water, similar results were obtained when compared to deionized water.

## Claims

1. An electrocaloric multilayer element (10) comprising a stack of layers along a transverse direction (11), said stack of layers comprising a first outermost polymer layer (15, 22, 32) and a second outermost polymer layer (16, 23, 33) at opposite ends of the stack and, between the first outermost polymer layer (15, 22, 32) and second outermost polymer (16, 23, 33), a plurality of electrocaloric polymer layers (12) and a plurality of electrode layers (13).

2. The electrocaloric multilayer element (10) according to claim 1, wherein the stack of layers comprises a plurality of units (14), each unit (14) comprising an electrocaloric polymer layer (12) and an electrode layer (13) deposited on the electrocaloric polymer layer (12).

3. The electrocaloric multilayer element (10) according to claim 2, wherein the stack of layers successively comprises, from one end of the stack to an opposite end of the stack: a first unit (14), wherein the electrocaloric polymer layer (12) of the first unit (14) is the first outermost polymer layer (15); second to last units (14), wherein the electrocaloric polymer layer (12) of each of the second to last units (14) is in contact with the electrode layer (13) of the preceding unit (14); the second outermost polymer layer (16), in contact with the electrode layer (13) of the last unit (14).

4. The electrocaloric multilayer element (10) according to claim 2, wherein the stack of layers successively comprises, from one end of the stack to an opposite end of the stack: the first outermost polymer layer (22); a first group (24) of units, comprising a first to last units (14), wherein the electrode layer (13) of the first unit (14) of the first group (24) is in contact with the first outermost polymer layer (22), and the electrode layer (13) of each of the second to last unit (14) of the first group (24) is in contact with the electrocaloric polymer layer (12) of the preceding unit (14) of the first group (24); a second group (25) of units, comprising a first to last units (14), wherein the electrocaloric polymer layer (12) of the first unit (14) of the second group (25) is joined with the electrocaloric polymer layer (12) of the last unit (14) of the first group (24), and the electrocaloric polymer layer (12) of each of the second to last unit (14) of the second group (25) is in contact with the electrode layer (13) of the preceding unit (14) of the second group (25); and the second outermost polymer layer (23) in contact with the electrode layer (13) of the last unit (14) of the second group (25).

5. The electrocaloric multilayer element (10) according to claim 2, wherein the stack of layers successively comprises, from one end of the stack to an opposite end of the stack: a first group (34) of units, comprising a first to last units (14), wherein the electrocaloric polymer layer (12) of the first unit (14) of the first group (34) is the first outermost polymer layer (32), and the electrocaloric polymer layer (12) of each of the second to last units (14) of the first group (34) is in contact with the electrode layer (13) of the preceding unit (14) of the first group (34); an intermediate polymer layer (36); a second group (35) of units (14), comprising a first to last units (14), wherein the electrocaloric polymer layer (12) of the last unit (14) of the second group (35) is the second outermost polymer layer (33), and the electrode layer (13) of each of the second to last units (14) of the second group (35) is in contact with the electrocaloric polymer layer (12) of the preceding unit (14) of the second group (35).

6. The electrocaloric multilayer element (10) according to any one of claims 2 to 5, wherein the total number of units (14) is from 2 to 100, preferably from 5 to 75 and more preferably from 10 to 50.

7. The electrocaloric multilayer element (10) according to any one of claims 1 to 6, comprising a plurality of stacks (51, 54, 57) of layers, wherein, preferably, the stacks (51, 54, 57) are formed as an integral element and the electrocaloric polymer layers are continuous from one stack to the next.

8. The electrocaloric multilayer element (10) according to any one of claims 1 to 7, wherein the or each stack comprises a first set (18) of electrode layers and a second set (19) of electrode layers, wherein the electrode layers (13) of the first (18) set alternate with the electrode layers (13) of the second set (19) along the transverse direction (11) in the or each stack.

9. The electrocaloric multilayer element (10) according to claim 8, comprising a first electrical contact (17) and a second electrical contact (17'), the first electrical contact (17) being electrically connected to the first set(s) (18) of electrode layers, preferably *via* respective leads (53), the second electrical contact (17') being electrically connected to the second set(s) (19) of electrode layers, preferably *via* respective leads (53').

10. The electrocaloric multilayer element (10) according to claim 9, wherein the first electrical contact (17) and the second electrical contact (17') are located on a same lateral face of the electrocaloric multilayer element (10).

11. The electrocaloric multilayer element (10) according to claim 9 or 10, wherein all electrode layers and leads, if present, are encapsulated in polymer material, whereas the first electrical contact (17) and the second electrical contact (17') are not encapsulated in polymer material.

12. The electrocaloric multilayer element (10) according to any one of claims 1 to 11, wherein each electrode layer (13) comprises a metal chosen among the group of transition metals, preferably the metal is aluminum, copper, nickel, magnesium, tungsten, molybdenum, manganese, titanium, vanadium, chromium gold or platinum, more preferably the metal is copper; and/or each electrode layer (13) has a thickness from 10 to 500 nm, preferably from 20 to 400 nm, preferably from 30 to 300 nm.

13. The electrocaloric multilayer element (10) according to any one of claims 1 to 12, wherein each electrocaloric polymer layer (12) has a thickness from 0.5 to 100 µm, preferably from 1 to 90 µm, preferably from 1.5 to 75 µm and more preferably from 2 to 50 µm.

14. The electrocaloric multilayer element (10) according to any one of claims 1 to 13, wherein each electrocaloric polymer layer (12) comprises a fluoropolymer comprising:
- a first repeat unit of formula -(CF₂-CH₂)-,
- optionally, a second repeat unit of formula -(CX₁X₂-CX₃X₄)-,
- optionally, a third repeat unit of formula -(CY₁Y₂-CY₃Z)-,
- optionally, a fourth repeat unit DB of formula -(CY₃=CF)-, -(CY₃=CX₁)-, -(CY₃=CX₂)-, -(CY₁=CY₃)-or -(CY₂=CY₃)-;
in which:
X₁ and X₂ are independently -H, -F, or an alkyl group comprising from 1 to 3 carbon atoms which is optionally partially or completely fluorinated,
X₃ and X₄ are independently -F or an alkyl group comprising from 1 to 3 carbon atoms which is optionally partially or completely fluorinated, except for the combination where: X₁ and X₂ are both: -H and X₃ and X₄ are both: -F,
Y₁ and Y₂ are independently -H, -F, -CI or an alkyl group comprising from 1 to 3 carbon atoms which is optionally partially or completely fluorinated,
Y₃ is -F, -Cl or an alkyl group comprising from 1 to 3 carbon atoms which is optionally partially or completely fluorinated,
Z is a halogen atom other than -F.

15. The electrocaloric multilayer element (10) according to claim 14, wherein the fluoropolymer is selected from P(VDF-TrFE), P(VDF-TrFE-CTFE), P(VDF-TrFE-CFE), P(VDF-TrFE-DB), P(VDF-TrFE-CTFE-DB) and P(VDF-TrFE-CFE-DB) and their mixture, wherein VDF represents repeat units derived from vinylidene fluoride, TrFE represents repeat units derived from trifluoroethylene, CTFE represents repeat units derived from chlorotrifluoroethylene, and CFE represents repeat units derived from 1,1- or 1,2-chlorofluoroethylene.

16. The electrocaloric multilayer element (10) according to any one of claims 1 to 15, wherein the stack has an electrocaloric active mass percentage from 50 to 99%, preferably 60 to 99% and more preferably 70 to 99%.

17. A process for producing the electrocaloric multilayer element (10) according to any one of claims 1 to 16, comprising assembling layers to form the stack of layers.

18. The process according to claim 17, comprising:
- a step of preparing a plurality of units (14), wherein each unit is made by depositing an electrode layer (13) onto an electrocaloric polymer layer (12);
- a step of assembling the plurality of units (14) together to form the stack of layers, preferably comprising performing thermal lamination, wherein more preferably the stack is heated to a temperature of 2 to 5°C below the melting point of the polymers of the electrocaloric polymer layers (12).

19. The process according to claim 17 or 18, wherein the step of thermal lamination further comprises performing recrystallization, wherein preferably the stack is heated to a temperature of 2 to 20°C below the melting point of the polymers of the electrocaloric polymer layers.

20. Use of the electrocaloric element according to any one of claims 1 to 16 for exchanging heat in contact with a heat-transfer liquid, the heat-transfer liquid being preferably chosen among water, an alcohol such as ethanol, ethylene glycol and propylene glycol, a silicone oil, a liquid metal or metal alloy such as galinstan, and being more preferably water.
